# EUROPEAN PATENT APPLICATION

(11) **EP 4 783 801 A1**
(43) Date of publication of application: **29.07.2026**
(21) Application number: 24868421.9
(22) Date of filing: 25.06.2024
(51) Int. Cl.: H10K 59/38, H10K 59/80, H10K 59/40, H10K 59/122

(54) **DISPLAY DEVICE**

(30) Priority: 18.09.2023 KR 20230124351
(71) Applicant: Samsung Display Co., Ltd., Yongin-si, Gyeonggi-do 17113 (KR)
(72) Inventor: KWON, Oh Jeong, Yongin-Si Gyeonggi-do 17113 (KR); KIM, Tae Ho, Yongin-Si Gyeonggi-do 17113 (KR); JEONG, Seung Yeon, Yongin-Si Gyeonggi-do 17113 (KR); SUH, Duck Jong, Yongin-Si Gyeonggi-do 17113 (KR); LEE, Mi Hwa, Yongin-Si Gyeonggi-do 17113 (KR); LEE, Hong Yeon, Yongin-Si Gyeonggi-do 17113 (KR)
(74) Representative: Gulde & Partner
(86) International application number: PCT/KR2024/008739
(87) International publication number: WO 2025/063434

(57) **Abstract**

A display device according to an embodiment comprises: a substrate; a light-emitting element layer disposed on the substrate and including a pixel-defining film by which a plurality of light-emitting areas and a non-light-emitting area are partitioned; an encapsulation layer disposed on the light-emitting element layer; a touch sensing layer disposed on the encapsulation layer and including a touch connection electrode, a driving electrode, and a color pattern which is disposed between the touch connection electrode and the driving electrode; a color filter layer disposed on the touch sensing layer and including a plurality of color filters; and an overcoat layer disposed on the color filter layer, wherein the color pattern overlaps the non-light-emitting area and one of the plurality of light-emitting areas, and the plurality of color filters do not overlap the light-emitting area overlapping the color pattern.

## Description

### [TECHNICAL FIELD]

The present disclosure relates to a display device.

### [BACKGROUND ART]

With the advance of information-oriented society, more and more demands are placed on display devices for displaying images in various ways. For example, display devices are employed in various electronic devices such as smartphones, digital cameras, laptop computers, navigation devices, and smart televisions.

The display device may be a flat panel display device such as a liquid crystal display device, a field emission display device and a light emitting display device. Examples of the light emitting display device include an organic light emitting display device composed of organic light emitting elements, an inorganic light emitting display device composed of inorganic light emitting elements such as inorganic semiconductors, and a micro light emitting display device composed of micro light emitting elements.

The organic light emitting element may include two opposing electrodes, and a light emitting layer interposed therebetween. The light emitting layer receives electrons and holes from the two electrodes and recombines them to generate excitons, and the generated excitons change from an excited state to a ground state, thereby emitting light.

The organic light emitting display device including organic light emitting elements is attracting attention as a next-generation display device because of being able to meet the high display quality requirements such as wide viewing angle, high brightness and contrast, and quick response speed as well as being able to be made having a low power consumption, lightweight, and thin due to no necessity of a power source such as a backlight unit.

### [DISCLOSURE]

### [TECHNICAL PROBLEM]

Aspects of the present disclosure provide a display device that includes a color filter disposed on a light emitting element, and is capable of reducing reflection of external light and improving light emission efficiency.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a display device comprises a substrate, a light emitting element layer disposed on the substrate, and comprising a pixel defining layer defining a plurality of emission areas and a non-emission area, an encapsulation layer disposed on the light emitting element layer, a touch sensing layer disposed on the encapsulation layer, and comprising a touch connection electrode, a driving electrode, and a color pattern disposed between the touch connection electrode and the driving electrode, a color filter layer disposed on the touch sensing layer, and comprising a plurality of color filters, and an overcoat layer disposed on the color filter layer, wherein the color pattern overlaps one of the plurality of emission areas and the non-emission area, and the plurality of color filters do not overlap the emission area which overlaps the color pattern.

The plurality of emission areas comprise a first emission area which emits first light, a second emission area which emits second light, and a third emission area which emits third light, and the color pattern overlaps any one emission area selected from the first emission area, the second emission area, and the third emission area.

The plurality of color filters are disposed to overlap different emission areas, respectively, among the remaining emission areas excluding the emission area overlapping the color pattern.

The first light is red light, the second light is blue light, and the third light is green light.

The color pattern overlaps the third emission area and does not overlap the first emission area and the second emission area.

The color pattern contains a colorant which transmits the third light and absorbs the first light and the second light.

The plurality of color filters comprise a first color filter which transmits the first light and a second color filter which transmits the second light, the first color filter overlaps the first emission area, and the second color filter overlaps the second emission area.

The color pattern and the plurality of color filters overlap each other in the non-emission area.

The color pattern has a refractive index smaller than that of the plurality of color filters.

The color pattern has a refractive index which is 0.05 or more smaller than the refractive index of the plurality of color filters.

The overcoat layer contains at least one of a dye with a maximum absorption wavelength of 490 nm or a dye with a maximum absorption wavelength of 590 nm.

The dye absorbs light in a wavelength band of 480 nm to 500 nm or 580 nm to 600 nm.

A lateral side of the color pattern is disposed at a distance of 2 µm or less outward from a lateral side of the pixel defining layer and at a distance of 1 µm or less inward from the lateral side of the pixel defining layer.

According to an aspect of the present disclosure, a display device comprises a substrate, a light emitting element layer disposed on the substrate, and comprising a pixel defining layer defining a plurality of emission areas and a non-emission area, an encapsulation layer disposed on the light emitting element layer, a touch sensing layer disposed on the encapsulation layer, and comprising a touch connection electrode, a driving electrode, and a color pattern disposed between the touch connection electrode and the driving electrode, a color filter layer disposed on the touch sensing layer, and comprising a first color filter and a second color filter, and an overcoat layer disposed on the color filter layer, wherein the color pattern overlaps one of the plurality of emission areas and the non-emission area, and the first color filter does not overlap the emission area which overlaps the color pattern, and the second color filter overlaps the emission area which overlaps the color pattern.

The plurality of emission areas comprise a first emission area which emits first light of a red color, a second emission area which emits second light of a blue color, and a third emission area which emits third light of a green color, and the color pattern overlaps the first emission area, the first color filter overlaps the second emission area, and the second color filter overlaps the first emission area and the third emission area.

The color pattern is a red color filter which transmits the first light, the first color filter is a blue color filter which transmits the second light, and the second color filter is a yellow color filter which transmits the first light and the third light.

The color pattern, the first color filter, and the second color filter overlap each other in the non-emission area.

The color pattern does not overlap the second emission area and the third emission area, the first color filter does not overlap the first emission area and the third emission area, and the second color filter does not overlap the second emission area.

According to an aspect of the present disclosure, a display device comprises a substrate, a light emitting element layer disposed on the substrate, and comprising a pixel defining layer defining a plurality of emission areas and a non-emission area, an encapsulation layer disposed on the light emitting element layer, a touch sensing layer disposed on the encapsulation layer, and comprising a plurality of touch electrodes, a color filter layer disposed on the touch sensing layer, and comprising a plurality of color filters, and an overcoat layer disposed on the color filter layer, wherein the plurality of color filters comprise a first color filter and a second color filter, the first color filter overlaps one of the plurality of emission areas, and the second color filter is disposed to overlap the remaining two or more emission areas among the plurality of emission areas.

The plurality of emission areas comprise a first emission area which emits first light of a red color, a second emission area which emits second light of a blue color, and a third emission area which emits third light of a green color, and the first color filter is a blue color filter which transmits the second light of the blue color, and the second color filter is a yellow color filter which transmits the first light of the red color and the third light of the green color.

The first color filter overlaps the second emission area and the non-emission area, and the second color filter overlaps the first emission area, the third emission area, and the non-emission area.

Other features and embodiments may be apparent from the following detailed description and the drawings.

### [ADVANTAGEOUS EFFECTS]

The display device according to one embodiment is capable of improving light efficiency and reducing reflection of external light by including a color pattern disposed in a touch sensing layer. Further, the color pattern and color filters or the color filters are disposed to overlap a non-emission area, thereby reducing the reflection of external light without a black matrix. Furthermore, an overcoat layer includes a colorant that absorbs light in a specific wavelength band, so that the reflection of external light can be reduced.

The effects according to the embodiments are not limited by the contents exemplified above, and more various effects are included in this disclosure.

### [DESCRIPTION OF DRAWINGS]

FIG. 1 is a schematic plan view of an electronic device according to one embodiment;
FIG. 2 is a perspective view illustrating a foldable display device in a folded state according to one embodiment;
FIG. 3 is a perspective view illustrating the foldable display device of FIG. 2 in an unfolded state;
FIG. 4 is a perspective view illustrating a display device included in an electronic device according to one embodiment;
FIG. 5 is a cross-sectional view of the display device of FIG. 4 viewed from the side;
FIG. 6 is a plan view illustrating a display layer of a display device according to one embodiment;
FIG. 7 is a plan view illustrating a touch sensing layer of a display device according to one embodiment;
FIG. 8 is a plan view of the disposition of the emission areas in the display area of the display device according to one embodiment;
FIG. 9 is a plan view illustrating the disposition of color filters disposed in the display area of FIG. 8;
FIG. 10 is a cross-sectional view taken along line X-X' of FIG. 8;
FIG. 11 is an enlarged cross-sectional view of a partial area of FIG. 10;
FIG. 12 is a cross-sectional view schematically showing an overcoat layer of a display device according to one embodiment;
FIG. 13 is an enlarged cross-sectional view of a partial area of FIG. 10;
FIG. 14 is a plan view showing the second emission area and the second opening;
FIGS. 15 to 18 are cross-sectional views for each step illustrating a manufacturing method of a display device according to one embodiment;
FIG. 19 is a cross-sectional view schematically illustrating a display device according to another embodiment;
FIG. 20 is a cross-sectional view schematically illustrating a display device according to still another embodiment;
FIG. 21 is a graph obtained by simulating a red light efficiency ratio according to a distance between lateral sides of a pixel defining layer and a color pattern;
FIG. 22 is a graph obtained by simulating a blue light efficiency ratio according to a distance between lateral sides of a pixel defining layer and of a color pattern;
FIG. 23 is a graph showing a transmittance by a wavelength band of a yellow color filter used in the simulation;
FIG. 24 is a graph showing a transmittance by a wavelength band of a dye with a maximum absorption wavelength of 490 nm used in the simulation; and
FIG. 25 is a graph showing a transmittance by a wavelength band of a dye with a maximum absorption wavelength of 590 nm used in the simulation.

### [MODES OF THE INVENTION]

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Hereinafter, exemplary embodiments of the present disclosure will be described with reference to the drawings.

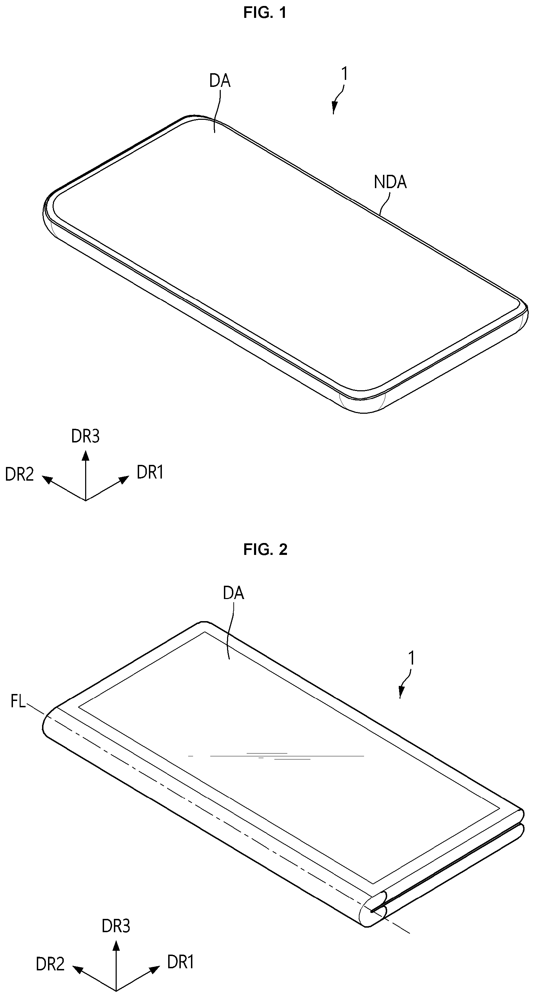

FIG. 1 is a schematic plan view of an electronic device according to one embodiment.

Referring to FIG. 1, an electronic device 1 displays a moving image or a still image. The electronic device 1 may refer to any electronic device providing a display screen. Examples of the electronic device 1 may include a television, a laptop computer, a monitor, a billboard, an Internet-of-Things device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder and the like, which provide a display screen.

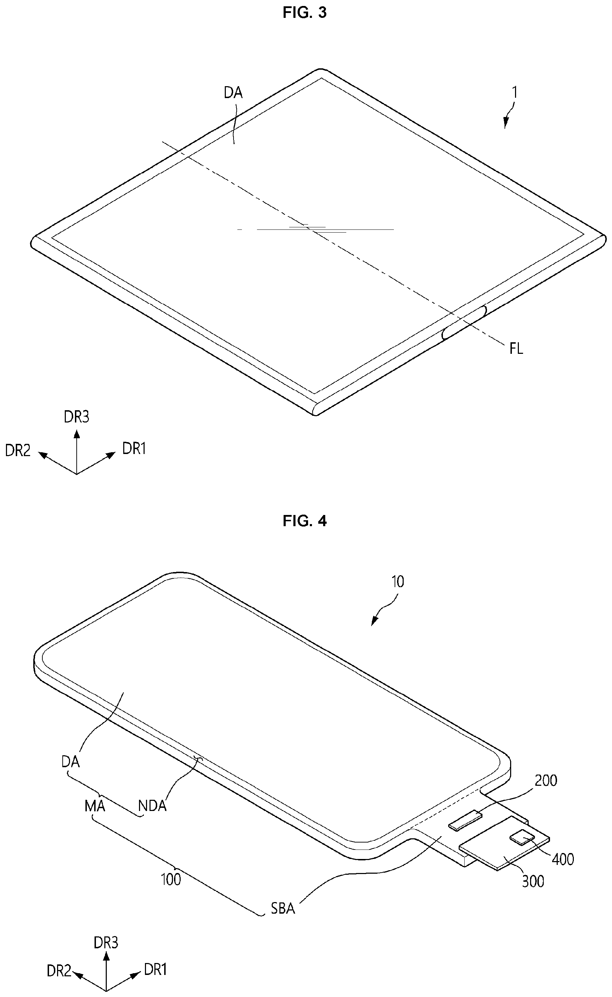

The electronic device 1 may include a display device 10 in FIG. 4 providing a display screen. Examples of the display device may include an inorganic light emitting diode display device, an organic light emitting display device, a quantum dot light emitting display device, a plasma display device and a field emission display device. In the following description, a case where an organic light emitting diode display device is applied as a display device will be exemplified, but the present disclosure is not limited thereto, and other display devices may be applied within the same scope of technical spirit.

The shape of the electronic device 1 may be variously modified. For example, the electronic device 1 may have a shape such as a rectangular shape elongated in a horizontal direction, a rectangular shape elongated in a vertical direction, a square shape, a quadrilateral shape with rounded corners (vertices), other polygonal shapes and a circular shape. The shape of a display area DA of the electronic device 1 may also be similar to the overall shape of the electronic device 1. FIG. 1 illustrates the electronic device 1 having a rectangular shape elongated in a second direction DR2.

The electronic device 1 may include the display area DA and a non-display area NDA. The display area DA is an area where a screen can be displayed, and the non-display area NDA is an area where a screen is not displayed. The display area DA may also be referred to as an active region, and the non-display area NDA may also be referred to as a non-active region. The display area DA may substantially occupy the center of the electronic device 1.

FIG. 2 is a perspective view illustrating a foldable display device in a folded state according to one embodiment. FIG. 3 is a perspective view illustrating the foldable display device of FIG. 2 in an unfolded state.

Referring to FIGS. 2 and 3, the electronic device 1 according to one embodiment may be a foldable display device. The foldable electronic device 1 may be folded around a folding axis FL. The display area DA may be disposed outside and/or inside of the foldable electronic device 1. In one embodiment, the foldable electronic device 1 of FIGS. 2 and 3 illustrates that the display area DA is disposed on each of the outside and the inside.

The display area DA may be disposed outside the electronic device 1. An outer surface of the folded electronic device 1 may include the display area DA, and an inner surface of the unfolded electronic device 1 may include the display area DA.

FIG. 4 is a perspective view illustrating a display device included in an electronic device according to one embodiment.

Referring to FIG. 4, the electronic device 1 according to one embodiment may include the display device 10. The display device 10 may provide a screen displayed by the electronic device 1. The display device 10 may have a planar shape similar to the shape of the electronic device 1. For example, the display device 10 may have a shape similar to a rectangular shape having a short side in a first direction DR1 and a long side in the second direction DR2. The edge where the short side in the first direction DR1 and the long side in the second direction DR2 meet may be rounded to have a curvature, but is not limited thereto and may be formed at a right angle. The planar shape of the display device 10 is not limited to a quadrilateral shape, and may be formed in a shape similar to another polygonal shape, a circular shape, or elliptical shape.

The display device 10 may include a display panel 100, a display driver 200, a circuit board 300, and a touch driver 400.

The display panel 100 may include a main region MA and a sub-region SBA.

The main region MA may include the display area DA including pixels displaying an image and the non-display area NDA disposed around the display area DA. The display area DA may emit light from a plurality of emission areas or a plurality of opening areas. For example, the display panel 100 may include a pixel circuit including switching elements, a pixel defining layer defining an emission area or an opening area, and a self-light emitting element.

For example, the self-light emitting element may include at least one of an organic light emitting diode (LED) including an organic light emitting layer, a quantum dot LED including a quantum dot light emitting layer, an inorganic LED including an inorganic semiconductor, or a micro LED, but is not limited thereto.

The non-display area NDA may be an area outside the display area DA. The non-display area NDA may be defined as an edge area of the main region MA of the display panel 100. The non-display area NDA may include a gate driver (not illustrated) that supplies gate signals to the gate lines, and fan-out lines (not illustrated) that connect the display driver 200 to the display area DA.

The sub-region SBA may be a region extending from one side of the main region MA. The sub-region SBA may include a flexible material which can be bent, folded or rolled. For example, when the sub-region SBA is bent, the sub-region SBA may overlap the main region MA in a thickness direction (third direction DR3). The sub-region SBA may include the display driver 200 and a pad portion connected to the circuit board 300. In another embodiment, the sub-region SBA may be omitted, and the display driver 200 and the pad portion may be arranged in the non-display area NDA.

The display driver 200 may output signals and voltages for driving the display panel 100. The display driver 200 may supply data voltages to data lines. The display driver 200 may supply a power voltage to the power line and may supply a gate control signal to the gate driver. The display driver 200 may be formed as an integrated circuit (IC) and mounted on the display panel 100 by a chip on glass (COG) method, a chip on plastic (COP) method, or an ultrasonic bonding method. For example, the display driver 200 may be disposed in the sub-region SBA, and may overlap the main region MA in the thickness direction by bending of the sub-region SBA. For another example, the display driver 200 may be mounted on the circuit board 300.

The circuit board 300 may be attached to the pad portion of the display panel 100 by using an anisotropic conductive film (ACF). Lead lines of the circuit board 300 may be electrically connected to the pad portion of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense an amount of change in capacitance between the plurality of touch electrodes. For example, the touch driving signal may be a pulse signal having a predetermined frequency. The touch driver 400 may calculate whether an input is made and input coordinates based on an amount of change in capacitance between the plurality of touch electrodes. The touch driver 400 may be formed as an integrated circuit (IC).

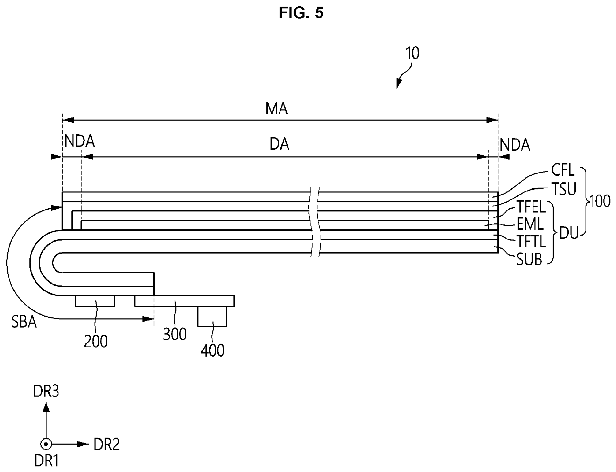

FIG. 5 is a cross-sectional view of the display device of FIG. 4 viewed from the side.

Referring to FIG. 5, the display panel 100 may include a display layer DU, a touch sensing layer TSU, and a color filter layer CFL. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate which can be bent, folded or rolled. For example, the substrate SUB may include a polymer resin such as polyimide (PI), but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines that connect the display driver 200 to the data lines, and lead lines that connect the display driver 200 to the pad portion. Each of the thin film transistors may include a semiconductor region, a source electrode, a drain electrode, and a gate electrode. For example, when the gate driver is formed on one side of the non-display area NDA of the display panel 100, the gate driver may include thin film transistors.

The thin film transistor layer TFTL may be disposed in the display area DA, the non-display area NDA, and the sub-region SBA. Thin film transistors, gate lines, data lines, and power lines of each of the pixels of the thin film transistor layer TFTL may be disposed in the display area DA. Gate control lines and fan-out lines of the thin film transistor layer TFTL may be disposed in the non-display area NDA. The lead lines of the thin film transistor layer TFTL may be disposed in the sub-region SBA.

The light emitting element layer EML may be disposed on the thin film transistor layer TFTL. The light emitting element layer EML may include a plurality of light emitting elements each including a first electrode, a second electrode, and a light emitting layer to emit light, and a pixel defining layer defining pixels. The plurality of light emitting elements of the light emitting element layer EML may be disposed in the display area DA.

In one embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives the cathode voltage, holes and electrons may be transferred to the organic light emitting layer through the hole transporting layer and the electron transporting layer, respectively and may be combined with each other to emit light in the organic light emitting layer.

In another embodiment, the light emitting elements may include a quantum dot light emitting diode including a quantum dot light emitting layer, an inorganic light emitting diode including an inorganic semiconductor, or a micro light emitting diode.

The encapsulation layer TFEL may cover the top surface and the side surface of the light emitting element layer EML, and may protect the light emitting element layer EML. The encapsulation layer TFEL may include at least one inorganic layer and at least one organic layer for encapsulating the light emitting element layer EML.

The touch sensing layer TSU may be disposed on the encapsulation layer TFEL. The touch sensing layer TSU may include a plurality of touch electrodes for sensing a user's touch in a capacitive manner, and touch lines connecting the plurality of touch electrodes to the touch driver 400. For example, the touch sensing layer TSU may sense the user's touch by using a mutual capacitance method or a self-capacitance method.

In another embodiment, the touch sensing layer TSU may be disposed on a separate substrate disposed on the display layer DU. In this case, the substrate supporting the touch sensing layer TSU may be a base member that encapsulates the display layer DU.

The plurality of touch electrodes of the touch sensing layer TSU may be disposed in a touch sensor area overlapping the display area DA. The touch lines of the touch sensing layer TSU may be disposed in a touch peripheral area that overlaps the non-display area NDA.

The color filter layer CFL may be disposed on the touch sensing layer TSU. The color filter layer CFL may include a plurality of color filters respectively corresponding to the plurality of emission areas. Each of the color filters may selectively transmit light of a specific wavelength and may block or absorb light of a different wavelength. The color filter layer CFL may absorb a portion of light coming from the outside of the display device 10 to reduce reflected light due to external light. Accordingly, the color filter layer CFL may prevent color distortion caused by reflection of the external light.

Since the color filter layer CFL is directly disposed on the touch sensing layer TSU, the display device 10 may not require a separate substrate for the color filter layer CFL. Accordingly, the thickness of the display device 10 may be relatively small.

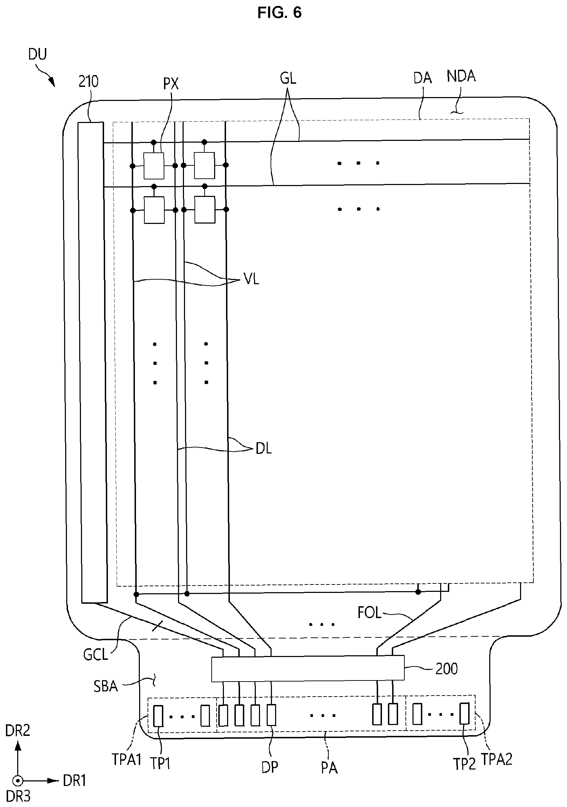

FIG. 6 is a plan view illustrating a display layer of a display device according to one embodiment.

Referring to FIG. 6, the display layer DU may include the display area DA and the non-display area NDA.

The display area DA may be disposed at the center of the display panel 100. A plurality of pixels PX, a plurality of gate lines GL, a plurality of data lines DL, and a plurality of power lines VL may be disposed in the display area DA. Each of the plurality of pixels PX may be defined as a minimum unit that emits light.

The plurality of gate lines GL may supply the gate signals received from a gate driver 210 to the plurality of pixels PX. The plurality of gate lines GL may extend in the first direction DR1 and may be spaced apart from each other in the second direction DR2 intersecting the first direction DR1.

The plurality of data lines DL may supply the data voltages received from the display driver 200 to the plurality of pixels PX. The plurality of data lines DL may extend in the second direction DR2 and may be spaced apart from each other in the first direction DR1.

The plurality of power lines VL may supply the power voltage received from the display driver 200 to the plurality of pixels PX. Here, the power voltage may be at least one of a driving voltage, an initialization voltage, a reference voltage, or a low potential voltage. The plurality of power lines VL may extend in the second direction DR2 and may be spaced apart from each other in the first direction DR1.

The non-display area NDA may surround the display area DA. The gate driver 210, fan-out lines FOL, and gate control lines GCL may be disposed in the non-display area NDA. The gate driver 210 may generate a plurality of gate signals based on the gate control signal, and may sequentially supply the plurality of gate signals to the plurality of gate lines GL according to a set order.

The fan-out lines FOL may extend from the display driver 200 to the display area DA. The fan-out lines FOL may supply the data voltage received from the display driver 200 to the plurality of data lines DL.

The gate control line GCL may extend from the display driver 200 to the gate driver 210. The gate control line GCL may supply the gate control signal received from the display driver 200 to the gate driver 210.

The sub-region SBA may include the display driver 200, a pad area PA, and first and second touch pad areas TPA1 and TPA2.

The display driver 200 may output signals and voltages for driving the display panel 100 to the fan-out lines FOL. The display driver 200 may supply a data voltage to the data line DL through the fan-out lines FOL. The data voltage may be supplied to the plurality of pixels PX, and the luminance of the plurality of pixels PX may be controlled. The display driver 200 may supply the gate control signal to the gate driver 210 through the gate control line GCL.

The pad area PA, the first touch pad area TPA1, and the second touch pad area TPA2 may be disposed at the edge of the sub-region SBA. The pad area PA, the first touch pad area TPA1, and the second touch pad area TPA2 may be electrically connected to the circuit board 300 by using a material such as self assembly anisotropic conductive paste (SAP) or an anisotropic conductive film.

The pad area PA may include a plurality of display pad portions DP. The plurality of display pad portions DP may be connected to a graphic system through the circuit board 300. The plurality of display pad portions DP may be connected to the circuit board 300 to receive digital video data, and may supply the digital video data to the display driver 200.

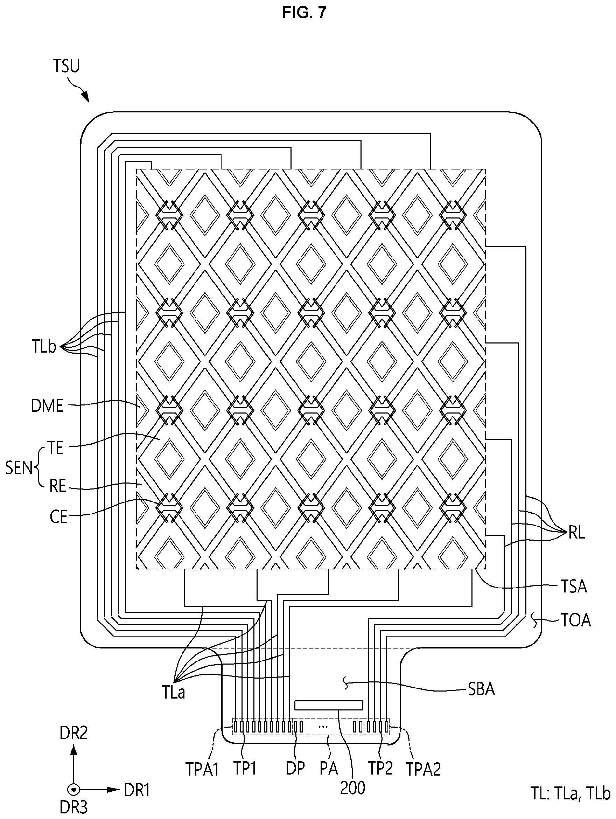

FIG. 7 is a plan view illustrating a touch sensing layer of a display device according to one embodiment.

Referring to FIG. 7, the touch sensing layer TSU may include a touch sensor area TSA for sensing a user's touch, and a touch peripheral area TOA disposed around the touch sensor area TSA. The touch sensor area TSA may be disposed in the display area DA of the display device 10, and the touch peripheral area TOA may be disposed in the non-display area NDA of the display device 10.

The touch sensor area TSA may include a plurality of touch electrodes SEN and a plurality of dummy electrodes DME. The plurality of touch electrodes SEN may form mutual capacitance or self-capacitance to sense a touch of an object or a person. The plurality of touch electrodes SEN may include a plurality of driving electrodes TE, a plurality of sensing electrodes RE, and a plurality of bridge electrodes CE.

The plurality of driving electrodes TE may be arranged in the first direction DR1 and the second direction DR2. The plurality of driving electrodes TE may be spaced apart from each other in the first direction DR1 and the second direction DR2. The driving electrodes TE adjacent in the second direction DR2 may be electrically connected through a bridge electrode CE.

The plurality of driving electrodes TE may be connected to a first touch pad unit TP1 through a driving line TL. The driving line TL may include a lower driving line TLa and an upper driving line TLb. For example, the driving electrodes TE disposed under the touch sensor area TSA may be connected to the first touch pad unit TP1 through the lower driving line TLa, and the driving electrodes TE disposed on the upper side of the touch sensor area TSA may be connected to the first touch pad unit TP1 through the upper driving line TLb. The lower driving line TLa may extend to the first touch pad unit TP1 through the lower side of the touch peripheral area TOA. The upper driving line TLb may extend to the first touch pad unit TP1 through the upper side, the left side, and the lower side of the touch peripheral area TOA. The first touch pad unit TP1 may be connected to the touch driver 400 through the circuit board 300.

The bridge electrode CE may be bent at least once. For example, the bridge electrode CE may have an angle bracket shape ("<" or ">"), but the planar shape of the bridge electrode CE is not limited thereto. The driving electrodes TE adjacent to each other in the second direction (Y-axis direction) may be connected by a plurality of bridge electrodes CE, and although any one of the bridge electrodes CE is disconnected, the driving electrodes TE may be stably connected through the remaining bridge electrode CE. The driving electrodes TE adjacent to each other may be connected by two bridge electrodes CE, but the number of bridge electrodes CE is not limited thereto.

The bridge electrode CE may be disposed on a different layer from the plurality of driving electrodes TE and the plurality of sensing electrodes RE. The sensing electrodes RE adjacent to each other in the first direction DR1 may be electrically connected through a connection portion disposed on the same layer as the plurality of driving electrodes TE or the plurality of sensing electrodes RE, and the driving electrodes TE adjacent in the second direction DR2 may be electrically connected through the bridge electrode CE disposed on a different layer from the plurality of driving electrodes TE or the plurality of sensing electrodes RE. Accordingly, although the bridge electrode CE overlaps the plurality of sensing electrodes RE in the Z-axis direction, the plurality of driving electrodes TE and the plurality of sensing electrodes RE may be insulated from each other. Mutual capacitance may be formed between the driving electrode TE and the sensing electrode RE.

The plurality of sensing electrodes RE may extend in the first direction DR1 and may be spaced apart from each other in the second direction DR2. The plurality of sensing electrodes RE may be arranged in the first direction DR1 and the second direction DR2, and the sensing electrodes RE adjacent in the first direction DR1 may be electrically connected through the connection portion.

The plurality of sensing electrodes RE may be connected to a second touch pad unit TP2 through a sensing line RL. For example, the sensing electrodes RE disposed on the right side of the touch sensor area TSA may be connected to the second touch pad unit TP2 through the sensing line RL. The sensing line RL may extend to the second touch pad unit TP2 through the right side and the lower side of the touch peripheral area TOA. The second touch pad unit TP2 may be connected to the touch driver 400 through the circuit board 300.

Each of the plurality of dummy electrodes DME may be surrounded by the driving electrode TE or the sensing electrode RE. Each of the dummy electrodes DME may be insulated by being spaced apart from the driving electrode TE or the sensing electrode RE. Accordingly, the dummy electrode DME may be electrically floating.

The pad area PA, the first touch pad area TPA1, and the second touch pad area TPA2 may be disposed at the edge of the sub-region SBA. The pad area PA, the first touch pad area TPA1, and the second touch pad area TPA2 may be electrically connected to the circuit board 300 by using a low-resistance high-reliability material such as self assembly anisotropic conductive paste (SAP) or an anisotropic conductive film.

The first touch pad area TPA1 may be disposed on one side of the pad area PA, and may include a plurality of first touch pad units TP1. The plurality of first touch pad units TP1 may be electrically connected to the touch driver 400 disposed on the circuit board 300. The plurality of first touch pad units TP1 may supply a touch driving signal to the plurality of driving electrodes TE through a plurality of driving lines TL.

The second touch pad area TPA2 may be disposed on the other side of the pad area PA, and may include a plurality of second touch pad units TP2. The plurality of second touch pad units TP2 may be electrically connected to the touch driver 400 disposed on the circuit board 300. The touch driver 400 may receive a touch sensing signal through a plurality of sensing lines RL connected to the plurality of second touch pad units TP2, and may sense a change in mutual capacitance between the driving electrode TE and the sensing electrode RE.

In another embodiment, the touch driver 400 may supply a touch driving signal to each of the plurality of driving electrodes TE and the plurality of sensing electrodes RE, and may receive a touch sensing signal from each of the plurality of driving electrodes TE and the plurality of sensing electrodes RE. The touch driver 400 may sense an amount of change in electric charge of each of the plurality of driving electrodes TE and the plurality of sensing electrodes RE based on the touch sensing signal.

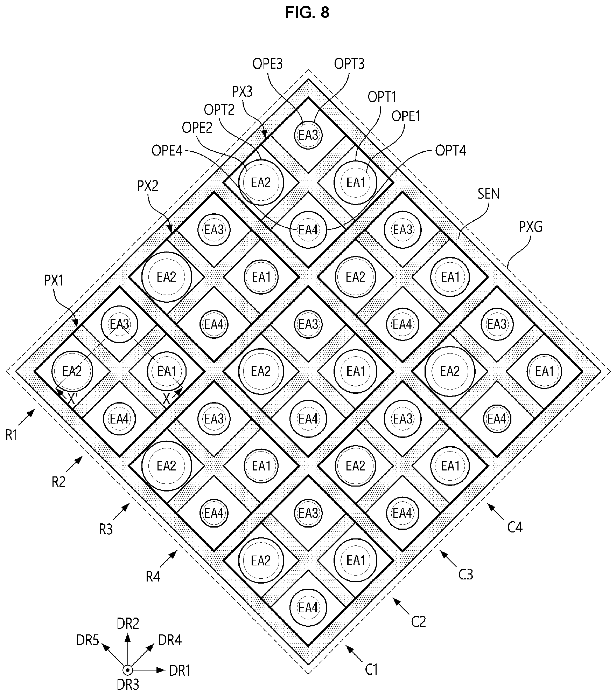

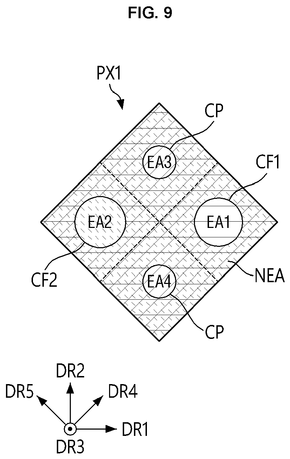

FIG. 8 is a plan view of the disposition of the emission areas in the display area of the display device according to one embodiment. FIG. 9 is a plan view illustrating the disposition of color filters disposed in the display area of FIG. 8.

Referring to FIGS. 8 and 9, the display device 10 may include a plurality of pixels PX1, PX2, and PX3 disposed in the display area DA and emission areas EA1, EA2, EA3, and EA4 and a non-emission area NEA disposed in each of the pixels PX1, PX2, and PX3. The plurality of pixels PX1, PX2, and PX3 may be arranged in a fourth direction DR4 and a fifth direction DR5 between the first direction DR1 and the second direction DR2. The first pixel PX1, the second pixel PX2, and the third pixel PX3 may be alternately disposed along the fourth direction DR4 and the fifth direction DR5. For example, the second pixel PX2 and the third pixel PX3 may be arranged in the fourth direction DR4 and the fifth direction DR5 with respect to the first pixel PX1. The plurality of pixels PX1, PX2, and PX3 may be disposed in a pentile^{TM} type, for example, a diamond pentile^{TM} type in the display area DA. However, the disposition or arrangement of the pixels PX1, PX2, and PX3 is not limited to those illustrated in FIGS. 8 and 9. In some embodiments, the plurality of pixels PX1, PX2, and PX3 may also be arranged in a linear or island-like pattern.

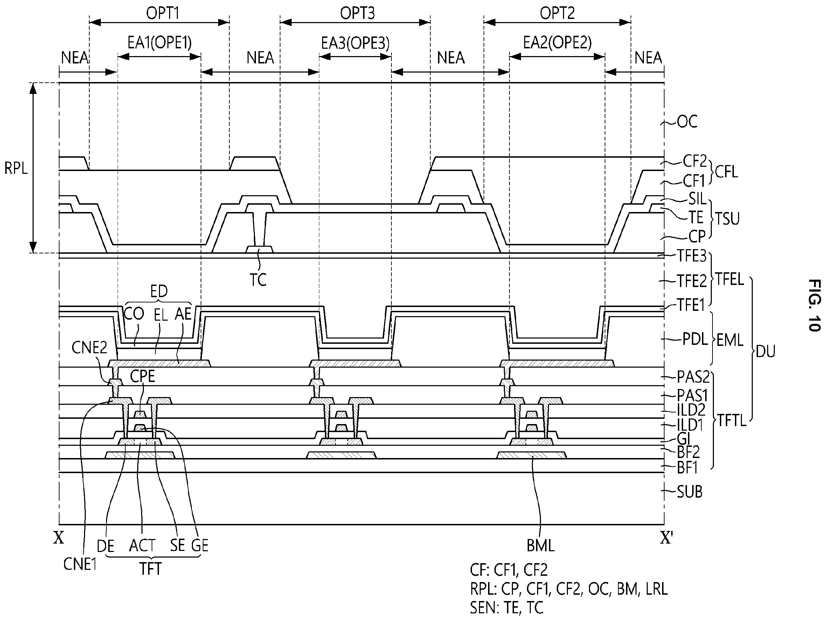

The emission areas EA1, EA2, EA3, and EA4 of each of the pixels PX1, PX2, and PX3 may include a first emission area EA1, a second emission area EA2, a third emission area EA3, and a fourth emission area EA4 that emit light of different colors. Unlike the first emission area EA1 and the second emission area EA2, the third emission area EA3 and the fourth emission area EA4 may emit light having the same color. The first to fourth emission areas EA1, EA2, EA3, and EA4 may emit red, blue, or green light, respectively, and the color of the light emitted from each of the emission areas EA1, EA2, EA3, and EA4 may be different depending on the type of a light emitting element ED in FIG. 10 disposed on a light emitting element layer EML to be described later. In an embodiment, the first emission area EA1 may emit first light of a red color, the second emission area EA2 may emit second light of a blue color, and the third emission area EA3 and the fourth emission area EA4 may emit third light of a green color. However, the present disclosure is not limited thereto.

The plurality of emission areas EA1, EA2, EA3, and EA4 may be disposed in a pentile^{TM} type, for example, a diamond pentile^{TM} type. For example, in each of the pixels PX1, PX2, and PX3, the first emission area EA1 and the second emission area EA2 may be disposed to be spaced apart from each other in the first direction DR1, and the third emission area EA3 and the fourth emission area EA4 may be disposed to be spaced apart from each other in the second direction DR2. The first emission area EA1 may be disposed to be spaced apart from the third emission area EA3 in the fifth direction DR5, and may be disposed to be spaced apart from the fourth emission area EA4 in the fourth direction DR4. The second emission area EA2 may be disposed to be spaced apart from the third emission area EA3 in the fourth direction DR4, and may be disposed to be spaced apart from the fourth emission area EA4 in the fifth direction DR5.

In the plurality of pixels PX1, PX2, and PX3, the plurality of first to fourth emission areas EA1, EA2, EA3, and EA4 may be alternately disposed in the fourth direction DR4 or the fifth direction DR5. For example, the plurality of emission areas EA1, EA2, EA3, and EA4 may be disposed in rows R1, R2, R3, and R4 arranged along the fourth direction DR4 and columns C1, C2, C3, and C4 arranged along the fifth direction DR5. In the first row R1 and the third row R3, the second emission area EA2 and the third emission area EA3 may be alternately disposed along the fourth direction DR4. In the second row R2 and the fourth row R4, the first emission area EA1 and the fourth emission area EA4 may be alternately disposed along the fourth direction DR4. In the first column C1 and the third column C3, the second emission area EA2 and the fourth emission area EA4 may be alternately disposed along the fifth direction DR5. In the second column C2 and the fourth column C4, the first emission area EA1 and the third emission area EA3 may be alternately disposed along the fourth direction DR4.

Alternatively, the plurality of emission areas EA1, EA2, EA3, and EA4 may be arranged along the first direction DR1 or the second direction DR2. The first emission area EA1 and the second emission area EA2 may be alternately disposed along the first direction DR1 and the second direction DR2. The third emission area EA3 and the fourth emission area EA4 may be alternately disposed along the first direction DR1 and the second direction DR2.

Each of the first to fourth emission areas EA1, EA2, EA3, and EA4 may be defined by a plurality of openings OPE1, OPE2, OPE3 and OPE4 formed in a pixel defining layer PDL (see FIG. 10) of the light emitting element layer EML to be described later. For example, the first emission area EA1 may be defined by the first opening OPE1 of the pixel defining layer, the second emission area EA2 may be defined by the second opening OPE2 of the pixel defining layer, the third emission area EA3 may be defined by the third opening OPE3 of the pixel defining layer, and the fourth emission area EA4 may be defined by the fourth opening OPE4 of the pixel defining layer.

In an embodiment, the areas or sizes of the first to fourth emission areas EA1, EA2, EA3, and EA4 may be different from each other. In the embodiment of FIG. 8, the area of the second emission area EA2 may be greater than the areas of the first emission area EA1, the third emission area EA3, and the fourth emission area EA4, and the area of the first emission area EA1 may be greater than the areas of the third emission area EA3 and the fourth emission area EA4. The areas of the emission areas EA1, EA2, EA3, and EA4 may vary according to the sizes of the openings OPE1, OPE2, OPE3, and OPE4 formed in the pixel defining layer. The intensity of light emitted from the corresponding emission areas EA1, EA2, EA3, and EA4 may vary according to the areas of the emission areas EA1, EA2, EA3, and EA4, and the areas of the emission areas EA1, EA2, EA3, and EA4 may be adjusted to control the color of the screen displayed on the display device 10 or the electronic device 1. In the embodiment of FIG. 8, the second emission area EA2 having the largest area is illustrated, but is not limited thereto. The areas of the emission areas EA1, EA2, EA3, and EA4 may be freely adjusted according to the color of the screen required by the display device 10 and the electronic device 1. In addition, the areas of the emission areas EA1, EA2, EA3, and EA4 may be related to light efficiency and the lifespan of the light emitting element ED, and may have a trade-off relation with the reflection by external light. The areas of the emission areas EA1, EA2, EA3, and EA4 may be adjusted in consideration of the above factors.

In addition, the plurality of openings OPE1, OPE2, OPE3, and OPE4 and a plurality of light output portions OPT1, OPT2, OPT3, and OPT4 are exemplarily shown and described as a circular shape. However, the present disclosure is not limited thereto, and various shapes, such as an oval shape or a polygonal structure with curved edges may be applied thereto.

Each of the plurality of pixels PX1, PX2, and PX3 may include the first to fourth emission areas EA1, EA2, EA3, and EA4 disposed adjacent to each other to express a white gray scale. However, the present disclosure is not limited thereto, and the combination of the emission areas EA1, EA2, EA3, and EA4 constituting one pixel group may be variously modified depending on the arrangement of the emission areas EA1, EA2, and EA3, the color of the light emitted from the emission areas EA1, EA2, EA3, and EA4, and the like.

The non-emission area NEA may be the remaining area excluding the emission areas EA1, EA2, EA3, and EA4. The non-emission area NEA may be disposed between the emission areas EA1, EA2, EA3, and EA4. The non-emission area NEA may overlap the pixel defining layer. For example, the non-emission area NEA may correspond to the area of the pixel defining layer.

The display device 10 may include a plurality of color filters CF1 and CF2 and color patterns CP disposed on the emission areas EA1, EA2, EA3, and EA4. The plurality of color filters CF1 and CF2 and color patterns CP may be disposed to correspond to the emission areas EA1, EA2, EA3, and EA4, respectively. For example, the color filters CF1 and CF2 and the color pattern CP may be disposed to overlap the emission areas EA1, EA2, EA3, and EA4, the openings OPE1, OPE2, OPE3, and OPE4, or the plurality of light output portions OPT1, OPT2, OPT3, and OPT4. The plurality of light output portions OPT1, OPT2, OPT3, and OPT4 may be formed to overlap the openings OPE1, OPE2, OPE3, and OPE4, and may form a light exit area from which the light emitted from the emission areas EA1, EA2, EA3, and EA4 is emitted. Each of the color filters CF1 and CF2 and the color patterns CP may have a larger area than the light output portions OPT1, OPT2, OPT3, and OPT4 and the openings OPE1, OPE2, OPE3, and OPE4, and each of the color filters CF1 and CF2 and the color patterns CP may completely cover the light exit area formed by the light output portions OPT1, OPT2, OPT3, and OPT4.

The color filters CF1 and CF2 and the color patterns CP may be disposed to correspond to the different emission areas EA1, EA2, EA3, and EA4, respectively. The color filters CF1 and CF2 may include a first color filter CF1 and a second color filter CF2. The color filters CF1 and CF2 and the color patterns CP may include a colorant such as a dye or a pigment that absorbs light in a wavelength band other than a specific wavelength band, and may be disposed to correspond to the color of the light emitted from the emission areas EA1, EA2, EA3, and EA4.

For example, the first color filter CF1 may be a red color filter that is disposed to overlap the first emission area EA1 and transmits only the first light of the red color. The second color filter CF2 may be a blue color filter that is disposed to overlap the second emission area EA2 and transmits only the second light of the blue color. The color pattern CP may be a green color filter that is disposed to overlap the third emission area EA3 and the fourth emission area EA4 and transmits only the third light of the green color.

The first color filter CF1 may be disposed to overlap the first emission area EA1 without overlapping the second emission area EA2, the third emission area EA3, and the fourth emission area EA4. The second color filter CF2 may be disposed to overlap the second emission area EA2 without overlapping the first emission area EA1, the third emission area EA3, and the fourth emission area EA4. The color pattern CP may be disposed to overlap the third emission area EA3 and the fourth emission area EA4 without overlapping the first emission area EA1 and the second emission area EA2. The color filters CF1 and CF2 and the color pattern CP may be disposed to overlap the non-emission area NEA.

According to one embodiment, the plurality of color filters CF1 and CF2 and color patterns CP may be disposed to partially overlap other adjacent color filters CF1 and CF2 and color patterns CP. FIG. 9 illustrates the disposition of the color filters CF1 and CF2 and the color pattern CP viewed from above. The color filters CF1 and CF2 and the color patterns CP, which overlap each other, may overlap each other in the non-emission area NEA.

In the display device 10, the color filters CF1 and CF2 and color patterns CP are disposed to overlap each other, so that the intensity of the reflected light by external light may be reduced. Furthermore, the color of the reflected light by the external light may be controlled by adjusting the disposition, shape, and area of the color filters CF1 and CF2 and color patterns CP in plan view.

The touch electrode SEN may be disposed between the emission areas EA1, EA2, EA3, and EA4. The touch electrode SEN may include the driving electrode TE and a touch connection electrode TC. Although not shown, it may include a sensing electrode. The touch electrode SEN may be disposed to extend in the fourth direction DR4 and the fifth direction DR5, and may be spaced apart the emission areas EA1, EA2, EA3, and EA4 from without overlapping them. The touch electrode SEN may be disposed to overlap the pixel defining layer PDL (see FIG. 10) including the openings OPE1, OPE2, OPE3, and OPE4. Additionally, the touch electrode SEN may overlap the first color filter CF1, the second color filter CF2, and the color pattern CP. Although the touch electrode SEN is briefly illustrated in FIG. 8, the touch electrode SEN may be either the touch driving electrode TE or the sensing electrode RE of FIG. 7.

Meanwhile, the diameters of the openings OPE1, OPE2, OPE3, and OPE4 forming the emission areas EA1, EA2, EA3, and EA4 may be smaller than the diameters of the light output portions OPT1, OPT2, OPT3, and OPT4. The light output portions OPT1, OPT2, OPT3, and OPT4 may be defined between the areas where the first color filter CF1, the second color filter CF2, and the color patterns CP overlap each other. An opening interval between the openings OPE1, OPE2, OPE3, and OPE4 and the light output portions OPT1, OPT2, OPT3, and OPT4 may be defined for each of the emission areas EA1, EA2, EA3, and EA4. The opening interval may also be defined as a difference in diameter between the openings OPE1, OPE2, OPE3, and OPE4 of the pixel defining layer PDL and the light output portions OPT1, OPT2, OPT3, and OPT4. In the display device 10, the same emission areas EA1, EA2, EA3, and EA4 belonging to the different pixels PX1, PX2, and PX3 may have different opening intervals between the openings OPE1, OPE2, OPE3, and OPE4 and the light output portions OPT1, OPT2, OPT3, and OPT4. In the first pixel PX1, the second pixel PX2, and the third pixel PX3, the emission areas EA1, EA2, EA3, and EA4 may emit light of the same color, but in each thereof, the opening intervals between the openings OPE1, OPE2, OPE3, and OPE4 and the light output portions OPT1, OPT2, OPT3, and OPT4 may be different.

For example, each of the first to third pixels PX1, PX2, and PX3 may include the first emission area EA1 emitting red light, but in each of the pixels PX1, PX2, and PX3, the opening intervals of the first emission areas EA1 may be different from each other. Similarly, in the first to third pixels PX1, PX2, and PX3, the second to fourth emission areas EA2, EA3, and EA4 may also emit light of the same color, but may have opening intervals different from each other. In addition, also in each of the pixels PX1, PX2, PX3, and PX4, the first to fourth emission areas EA1, EA2, EA3, and EA4 may have opening intervals different from each other.

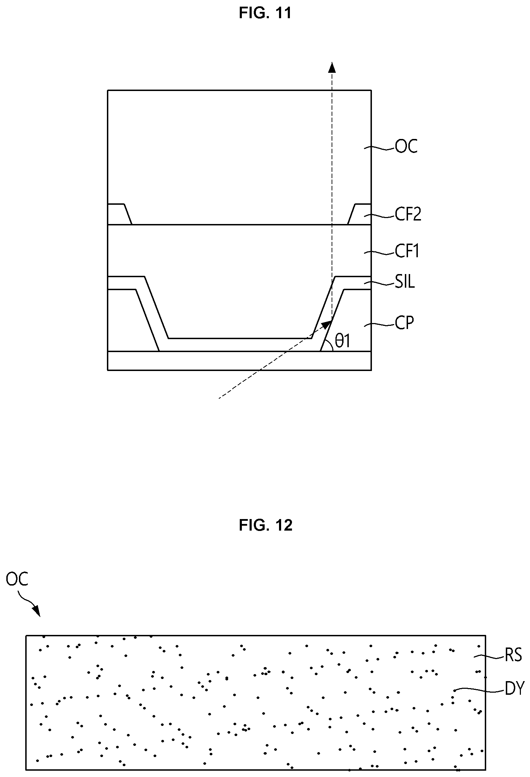

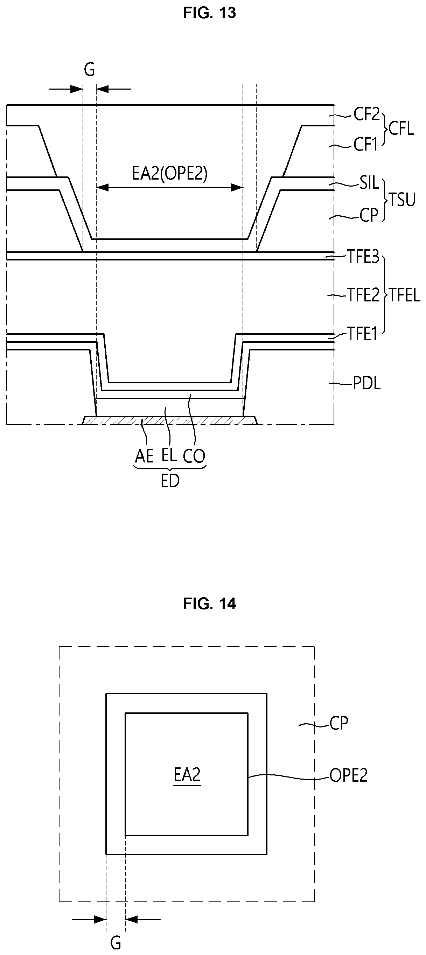

FIG. 10 is a cross-sectional view taken along line X-X' of FIG. 8. FIG. 11 is an enlarged cross-sectional view of a partial area of FIG. 10. FIG. 12 is a cross-sectional view schematically showing an overcoat layer of a display device according to one embodiment. FIG. 13 is an enlarged cross-sectional view of a partial area of FIG. 10. FIG. 14 is a plan view showing the second emission area and the second opening.

FIG. 10 illustrates a cross section crossing the first emission area EA1, the third emission area EA3, and the second emission area EA2.

A cross-sectional structure of the display device 10 will be described with reference to FIGS. 10 to 14 in addition to FIGS. 8 and 9.

The display panel 100 of the display device 10 according to one embodiment may include the display layer DU, the touch sensing layer TSU, the color filter layer CFL, and an overcoat layer OC. The display layer DU may include the substrate SUB, the thin film transistor layer TFTL, the light emitting element layer EML, and the encapsulation layer TFEL. The display panel 100 may include a reflection reduction layer RPL on the encapsulation layer TFEL. The reflection reduction layer RPL may include the touch sensing layer TSU, the color filter layer CFL, and the overcoat layer OC.

The substrate SUB may be a base substrate or a base member. The substrate SUB may be a flexible substrate which can be bent, folded or rolled. For example, the substrate SUB may include a polymer resin such as polyimide (PI), but is not limited thereto. For another example, the substrate SUB may include a glass material or a metal material.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be disposed on the substrate SUB. The first buffer layer BF1 may include an inorganic layer capable of preventing penetration of air or moisture. For example, the first buffer layer BF1 may include a plurality of inorganic layers alternately stacked.

The lower metal layer BML may be disposed on the first buffer layer BF1. For example, the lower metal layer BML may be formed as a single layer or multiple layers made of any one of molybdenum (Mo), aluminum (Al), chromium (Cr), gold (Au), titanium (Ti), nickel (Ni), neodymium (Nd), tantalum (Ta), and copper (Cu) or an alloy thereof.

The second buffer layer BF2 may cover the first buffer layer BF1 and the lower metal layer BML. The second buffer layer BF2 may include an inorganic layer capable of preventing penetration of air or moisture. For example, the second buffer layer BF2 may include a plurality of inorganic layers alternately stacked.

The thin film transistor TFT may be disposed on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction, and may be insulated from the gate electrode GE by the gate insulating layer GI. In a portion of the semiconductor layer ACT, a material of the semiconductor layer ACT may be made into a conductor to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF to insulate the gate electrode GE from the semiconductor layer ACT. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may include a contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be disposed on the first interlayer insulating layer ILD1. The capacitor electrode CPE may overlap the gate electrode GE in the thickness direction. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be disposed on the second interlayer insulating layer ILD2. The first connection electrode CNE1 may electrically connect the drain electrode DE of the thin film transistor TFT to the second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be disposed on the first passivation layer PAS1. The second connection electrode CNE2 may electrically connect the first connection electrode CNE1 to a pixel electrode AE of the light emitting element ED. The second connection electrode CNE2 may be inserted into a contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may include a contact hole through which the pixel electrode AE of the light emitting element ED passes.

The light emitting element layer EML may be disposed on the thin film transistor layer TFTL. The light emitting element layer EML may include the light emitting element ED and a pixel defining layer PDL. The light emitting element ED may include the pixel electrode AE, a light emitting layer EL, and a common electrode CO.

The pixel electrode AE may be disposed on the second passivation layer PAS2. The pixel electrode AE may be disposed to overlap any one of the openings OPE1, OPE2, OPE3, and OPE4 of the pixel defining layer PDL. The pixel electrode AE may be electrically connected to the drain electrode DE of the thin film transistor TFT through the first and second connection electrodes CNE1 and CNE2.

The light emitting layer EL may be disposed on the pixel electrode AE. For example, the light emitting layer EL may be an organic light emitting layer made of an organic material, but is not limited thereto. In the case of employing the organic light emitting layer as the light emitting layer EL, the thin film transistor TFT applies a predetermined voltage to the pixel electrode AE of the light emitting element ED, and if the common electrode CO of the light emitting element ED receives a common voltage or a cathode voltage, the holes and electrons can move to the light emitting layer EL through the hole transporting layer and the electron transporting layer and combine to produce light to be emitted by the light emitting layer EL.

The common electrode CO may be arranged on the light emitting layer EL. For example, the common electrode CO may be made in the form of an electrode common to all of the pixels rather than specific to each of the pixels. The common electrode CO may be disposed on the light emitting layer EL in the first to fourth emission areas EA1, EA2, EA3, and EA4, and may be disposed on the pixel defining layer PDL in an area other than the first to fourth emission areas EA1, EA2, EA3, and EA4.

The common electrode CO may receive the common voltage or a low potential voltage. When the pixel electrode AE receives a voltage corresponding to a data voltage and the common electrode CO receives the low potential voltage, a potential difference is formed between the pixel electrode AE and the common electrode CO, so that the light emitting layer EL may emit light.

The pixel defining layer PDL may include the plurality of openings OPE1, OPE2, OPE3, and OPE4, and may be disposed on a portion of the second passivation layer PAS2 and the pixel electrode AE. The pixel defining layer PDL may include the first opening OPE1, the second opening OPE2, the third opening OPE3, and the fourth opening OPE4, and each of the openings OPE1, OPE2, OPE3, and OPE4 may expose a portion of the pixel electrode AE. As described above, each of the openings OPE1, OPE2, OPE3, and OPE4 of the pixel defining layer PDL may define the first to fourth emission areas EA1, EA2, EA3, and EA4, and the areas or sizes of the openings OPE1, OPE2, OPE3, and OPE4 may be different. The pixel defining layer PDL may separate and insulate the pixel electrode AE of each of the plurality of light emitting elements ED.

The pixel defining layer PDL may include a light absorbing material to prevent light reflection. For example, the pixel defining layer PDL may include a polyimide (PI)-based binder and a pigment in which red, green, and blue colors are mixed. Alternatively, the pixel defining layer PDL may include a cardo-based binder resin and a mixture of a lactam black pigment and a blue pigment. Alternatively, the pixel defining layer PDL may include carbon black.

The encapsulation layer TFEL may be disposed on the common electrode CO to cover the plurality of light emitting elements ED. The encapsulation layer TFEL may include at least one inorganic layer to prevent oxygen or moisture from penetrating into the light emitting element layer EML. The encapsulation layer TFEL may include at least one organic layer to protect the light emitting element layer EML from foreign matters such as dust.

In an embodiment, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 disposed between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminum oxide, titanium oxide, tantalum oxide, hafnium oxide, zinc oxide, silicon oxide, silicon nitride, and/or silicon oxynitride.

The second encapsulation layer TFE2 may include a polymer-based material. Examples of the polymer-based material may include acrylic resin, epoxy resin, polyimide, polyethylene and the like. For example, the organic encapsulation layer 320 may include an acrylic resin, for example, polymethyl methacrylate, polyacrylic acid, or the like. The second encapsulation layer TFE2 may be formed by curing a monomer or applying a polymer.

The touch sensing layer TSU may be disposed on the encapsulation layer TFEL. The touch sensing layer TSU may include the color pattern CP, the touch electrode SEN, and a passivation layer SIL.

The color pattern CP may be disposed on the encapsulation layer TFEL. The color pattern CP may be disposed to overlap the third emission area EA3, the fourth emission area EA4, the third opening OPE3, and the non-emission area NEA. The color pattern CP may be disposed so as not to overlap the first emission area EA1 and the second emission area EA2.

The color pattern CP may selectively transmit light of a specific wavelength and may block or absorb light of a different wavelength. The color pattern CP may include a colorant dispersed in a polymer resin. The polymer resin may be a material that is transparent and has a low refractive index. The polymer resin may have a refractive index of 1.4 to 1.6. For example, the polymer resin may include one or more selected from acryl, epoxy, phenol, polyimide, and polyamide resin. The color pattern CP may include a colorant such as a dye or a pigment that absorbs light of a wavelength band other than a specific wavelength band. The color pattern CP may be a green color filter that transmits only the third light of the green color, and may absorb the first light of the red color and the second light of the blue color. The color pattern CP may be formed by coating a solution in which a polymer resin and a colorant are mixed and curing it.

In another embodiment, the color pattern CP may further include a hollow particle. The hollow particle may serve to lower the refractive index of the color pattern CP. For example, the hollow particle may include one or more selected from the group consisting of silica (SiO₂), magnesium fluoride (MgF₂), and iron oxide (Fe₃O₄). The hollow particle included in the color pattern CP may be included in a weight ratio of 1% to 50% relative to a polymer resin, thereby lowering the refractive index of the color pattern CP.

The side surface of the color pattern CP, which is adjacent to each of the emission areas EA1, EA2, EA3, and EA4, may be an inclined surface. An inclination angle θ1 of the inclined surface may be about 60 to 85 degrees, and preferably 70 to 75 degrees. A portion of light emitted from the light emitting elements ED of each emission area EA1, EA2, EA3, EA4 may be emitted directly toward the upper portion where the overcoat layer OC is disposed, while another portion of the light may proceed toward the inclined surface of the color pattern CP. In this case, the inclined surface of the color pattern CP acts as a total reflection surface, so that the light incident on the inclined surface of the color pattern CP may be totally reflected to be emitted upward.

The color pattern CP may have a smaller refractive index than the first color filter CF1 and the second color filter CF2. The refractive index of the color pattern CP may be 0.05 or more smaller than the refractive index of the first color filter CF1 and the refractive index of the second color filter CF2. A portion of light refracted at the inclined surface of the color pattern CP may be refracted upward at the boundary of the first color filter CF1 having a relatively high refractive index, thereby improving the light emission efficiency.

In the touch electrode SEN, the touch connection electrode TC may be disposed under the color pattern CP, and the driving electrode TE may be disposed on the color pattern CP. Although not shown, the sensing electrode RE of the touch electrode SEN may be disposed on the color pattern CP. The touch connection electrode TC may be a bridge electrode. Each of the touch electrodes SEN may not overlap the first to fourth emission areas EA1, EA2, EA3, and EA4. The color pattern CP may function as an insulating layer that insulates the touch electrodes SEN. For example, the color pattern CP may insulate the driving electrode TE from the sensing electrode.

Each of the touch electrodes SEN may be formed of a single layer containing molybdenum (Mo), titanium (Ti), copper (Cu), tantalum (Ta), aluminum (Al), or indium tin oxide (ITO), or may be formed to have a stacked structure (Ti/Al/Ti) of aluminum and titanium, a stacked structure (ITO/Al/ITO) of aluminum and ITO, an Ag-Pd-Cu (APC) alloy, or a stacked structure (ITO/APC/ITO) of APC alloy and ITO.

The passivation layer SIL may insulate the driving electrode TE, and may serve to protect the lower color pattern CP from subsequent processes. The passivation layer SIL may cover the driving electrode TE and the color pattern CP. The passivation layer SIL may be in direct contact with the third encapsulation layer TFE3 of the encapsulation layer TFEL in each of the emission areas EA1, EA2, EA3, and EA4.

The color filter layer CFL may be disposed on the touch sensing layer TSU. The color filter layer CFL may include the first color filter CF1 and the second color filter CF2.

The first color filter CF1 may be disposed on the passivation layer SIL. The first color filter CF1 may be disposed to overlap the first emission area EA1, the first opening OPE1, and the non-emission area NEA. The first color filter CF1 may be disposed so as not to overlap the second emission area EA2, the third emission area EA3, and the fourth emission area EA4. In addition, the first color filter CF1 may be disposed to overlap the color pattern CP in an area other than the first emission area EA1. For example, the first color filter CF1 may be disposed to overlap the color pattern CP in the non-emission area NEA.

The first color filter CF1 may selectively transmit light of a specific wavelength and may block or absorb light of a different wavelength. The first color filter CF1 may be a red color filter that transmits only the first light of the red color, and may absorb the second light of the blue color and the third light of the green color.

The second color filter CF2 may be disposed on the passivation layer SIL and the first color filter CF1. The second color filter CF2 may be disposed to overlap the second emission area EA2, the second opening OPE2, and the non-emission area NEA. The second color filter CF2 may be disposed so as not to overlap the first emission area EA1, the third emission area EA3, and the fourth emission area EA4.

The second color filter CF2 may selectively transmit light of a specific wavelength and may block or absorb light of a different wavelength. The second color filter CF2 may be a blue color filter that transmits only the second light of the blue color, and may absorb the first light of the red color and the third light of the green color.

In one embodiment, the second color filter CF2 may be disposed to overlap the color pattern CP and the first color filter CF1 in an area other than the second emission area EA2. For example, the second color filter CF2 may be disposed to overlap the color pattern CP and the first color filter CF1 in the non-emission area NEA. In the remaining area excluding the emission areas EA1, EA2, EA3, and EA4, the color pattern CP, the first color filter CF1, and the second color filter CF2 may overlap each other to act as a black matrix. As a result, it is possible to prevent visible light interference among the emission areas EA1, EA2, EA3, and EA4, which causes color mixture, thereby improving color reproducibility of the display device 10. In addition, since the black matrix may be omitted, the structure may be simplified.

The overcoat layer OC may be disposed on the color filter layer CFL. The overcoat layer OC may cover the color filter layer CFL to flatten the lower step. The overcoat layer OC may include an organic material, and may include, for example, polyimide (PI).

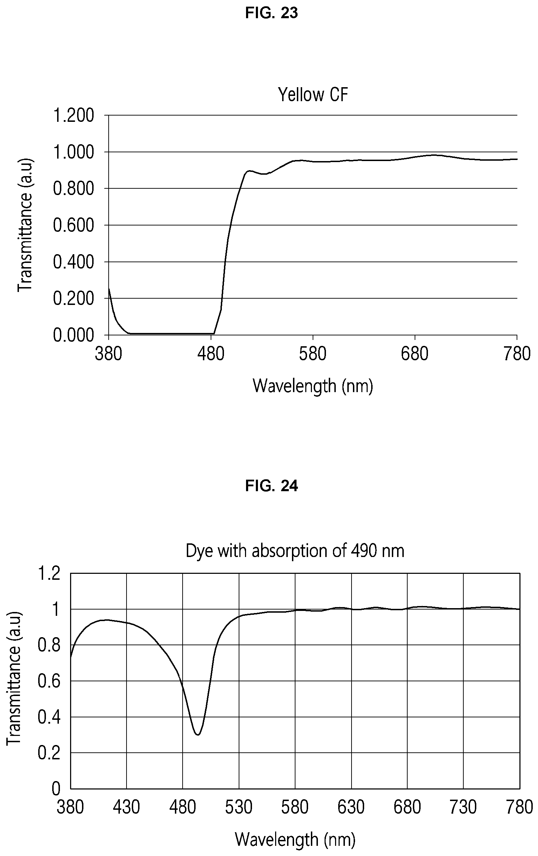

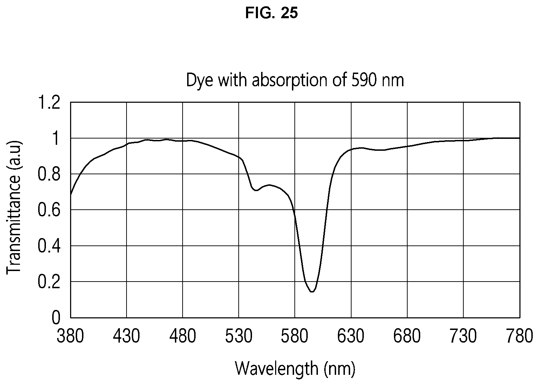

As shown in FIG. 12, the overcoat layer OC may further include a dye that may selectively absorb light in a specific wavelength band. The overcoat layer OC may reduce the reflectance of external light by absorbing light in a partial wavelength band of light incident from the outside. The overcoat layer OC may include a dye DY mixed with a polymer resin RS. The dye DY may include a dye with a maximum absorption wavelength of 490 nm or 590 nm. Here, the maximum absorption wavelength may refer to the peak wavelength at which the light transmittance is the lowest in FIGS. 24 and 25. For example, the dye DY may include a dye that may absorb light in a wavelength band of 480 nm to 500 nm or light in a wavelength band of 580 nm to 600 nm.

According to this embodiment, the color pattern CP of the touch sensing layer TSU, the color filter layer CFL, and the overcoat layer OC may be included as the reflection reduction layer RPL. The reflection reduction layer RPL may reduce the reflection of light incident from the outside. When external light is incident, light in a partial wavelength band is absorbed in the overcoat layer OC, light in a partial wavelength band is absorbed in the color filter layer CFL, and light in a partial wavelength band is absorbed in the color pattern CP. Accordingly, most of the external light incident on the display device 10 is absorbed by the reflection reduction layer RPL, so that the amount of light reflected back to the outside may be significantly reduced.

In addition, since the color pattern CP is formed to have a low refractive characteristic with a total reflection surface, light emitted from each of the emission areas EA1, EA2, EA3, and EA4 is reflected upward, thereby improving the light emission efficiency.

Referring to FIGS. 13 and 14, the display device 10 according to one embodiment may be formed to have a predetermined distance G between each of the emission areas EA1, EA2, EA3, and EA4 and the side surface of each color pattern CP. Hereinafter, the second emission area EA2 will be described as an example.

The second emission area EA2 may be defined as the second opening OPE2 of the pixel defining layer PDL. That is, the second emission area EA2 may be an area surrounded by the lateral sides of the pixel defining layer PDL. In plan view, the second emission area EA2 may be surrounded by the lateral sides of the color pattern CP.

According to one embodiment, the lateral side of the pixel defining layer PDL in each emission area EA1, EA2, EA3, EA4 may be disposed within the predetermined distance G from the lateral side of the color pattern CP surrounding the corresponding emission area in plan view. For example, the distance G between the lateral side of the pixel defining layer PDL and the lateral side of the color pattern CP may be in a range of -1 µm to +2 µm. Preferably, the distance G between the lateral side of the pixel defining layer PDL and the lateral side of the color pattern CP may be in a range of -0.5 µm to +1.5 µm. In this case, plus (+) may refer to a distance by which the lateral side of the color pattern CP is spaced outward from the lateral side of the pixel defining layer PDL, and minus (-) may refer to a distance by which the lateral side of the color pattern CP is spaced inward from the lateral side of the pixel defining layer PDL. In addition, the outside from the lateral side of the pixel defining layer PDL refers to the outside of the second emission area EA2, and the inside from the lateral side of the pixel defining layer PDL refers to the inside of the second emission area EA2. For example, the distance by which the lateral side of the color pattern CP is spaced outward from the lateral side of the pixel defining layer PDL may be 2 µm or less. The distance by which the lateral side of the color pattern CP is spaced inward from the lateral side of the pixel defining layer PDL may be 1 µm or less. The lateral side of the color pattern CP may be disposed at a distance of 2 µm or less outward from the lateral side of the pixel defining layer PDL and at a distance of 1 µm or less inward from the lateral side of the pixel defining layer PDL.

If the distance between the lateral side of the pixel defining layer PDL and the lateral side of the color pattern CP is in the aforementioned range, it is possible to improve the emission efficiency of light that is emitted from the light emitting element ED, is totally reflected on the lateral side (e.g., the inclined surface) of the color pattern CP, and proceeds upward.

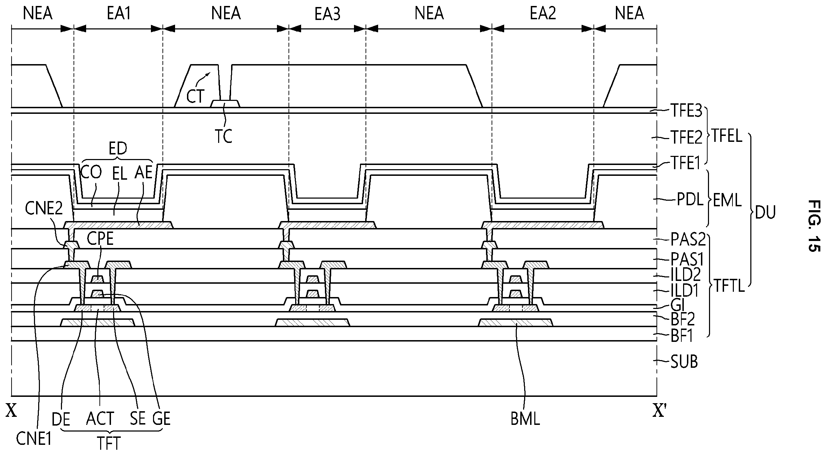

FIGS. 15 to 18 are cross-sectional views for each step illustrating a manufacturing method of a display device according to one embodiment. The manufacturing method of the display device of FIGS. 15 to 18 will be described by way of example of manufacturing the display device in accordance with the structure of FIG. 10. Additionally, the manufacturing processes of the display layer DU will be briefly described.

Referring to FIG. 15, the thin film transistor layer TFTL, the light emitting element layer EML, and the encapsulation layer TFEL are formed on the substrate SUB. The thin film transistor layer TFTL, the light emitting element layer EML, and the encapsulation layer TFEL may be formed using a photolithography process, an inkjet printing process, and the like.

The touch connection electrode TC is formed on the encapsulation layer TFEL. The touch connection electrode TC may be formed by laminating a conductive layer and patterning it through a photolithography process.

Next, the color pattern CP is formed on the encapsulation layer TFEL on which the touch connection electrode TC is formed. The color pattern CP may be formed by applying a solution containing a polymer resin and a colorant and performing a photolithography process using a mask. The color pattern CP may be formed to overlap the third emission area EA3 without overlapping the first emission area EA1 and the second emission area EA2. Additionally, the color pattern CP may be formed to overlap the non-emission area NEA. A contact hole CT exposing the touch connection electrode TC may be formed in the color pattern CP.

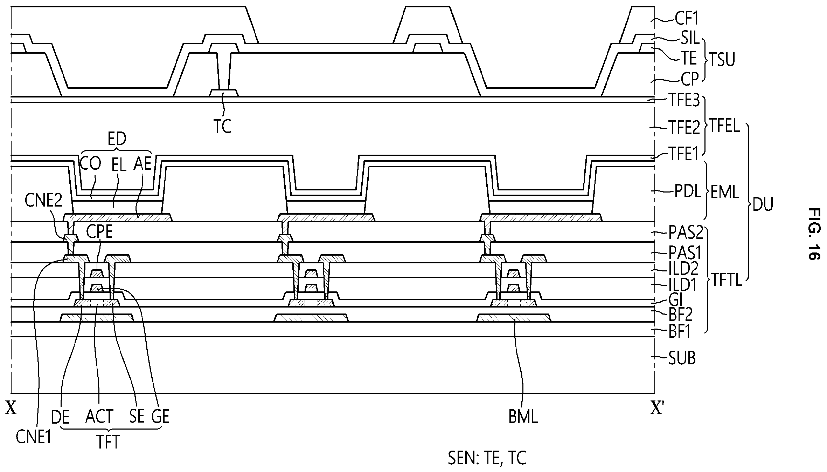

Thereafter, referring to FIG. 16, the driving electrode TE of the touch electrode SEN is formed on the color pattern CP. The driving electrode TE may be formed by laminating a conductive layer and patterning it through a photolithography process. The driving electrode TE may be connected to the touch connection electrode TC through the contact hole CT of the color pattern CP.

Subsequently, an inorganic or an organic material is applied on the substrate SUB, on which the driving electrode TE is formed, to form the passivation layer SIL. The passivation layer SIL may be formed across the emission areas EA1, EA2, and EA3 and the non-emission area NEA. Accordingly, the touch sensing layer TSU including the color pattern CP, the touch connection electrode TC, the driving electrode TE, and the passivation layer SIL is formed.

Next, the first color filter CF1 is formed on the passivation layer SIL. The first color filter CF1 may be formed by applying a solution containing a polymer resin and a colorant and performing a photolithography process using a mask. The first color filter CF1 may be formed to overlap the first emission area EA1 without overlapping the second emission area EA2 and the third emission area EA3. In addition, the first color filter CF1 may be formed to overlap the color pattern CP of the non-emission area NEA.

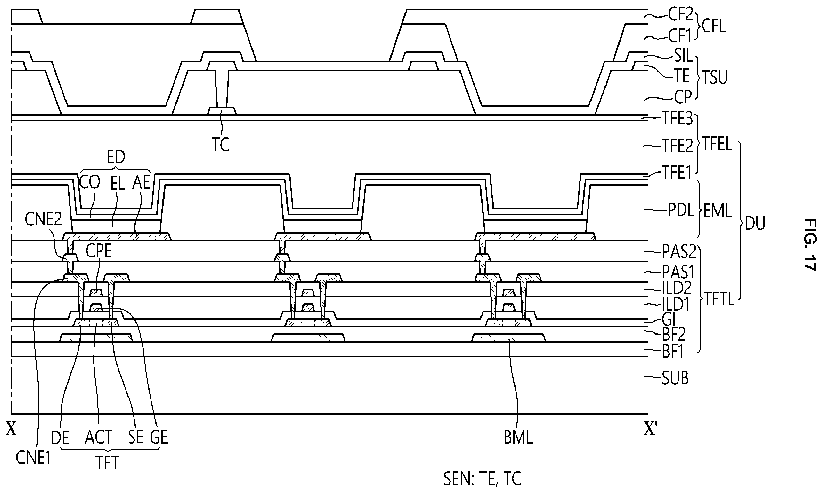

Next, referring to FIG. 17, the second color filter CF2 is formed on the first color filter CF1. The second color filter CF2 may be formed by applying a solution containing a polymer resin and a colorant and performing a photolithography process using a mask. The second color filter CF2 may be formed to overlap the second emission area EA2 without overlapping the first emission area EA1 and the third emission area EA3. In addition, the second color filter CF2 may be formed to overlap the color pattern CP of the non-emission area NEA and the first color filter CF1. Accordingly, the color filter layer CFL including the first color filter CF1 and the second color filter CF2 is formed.

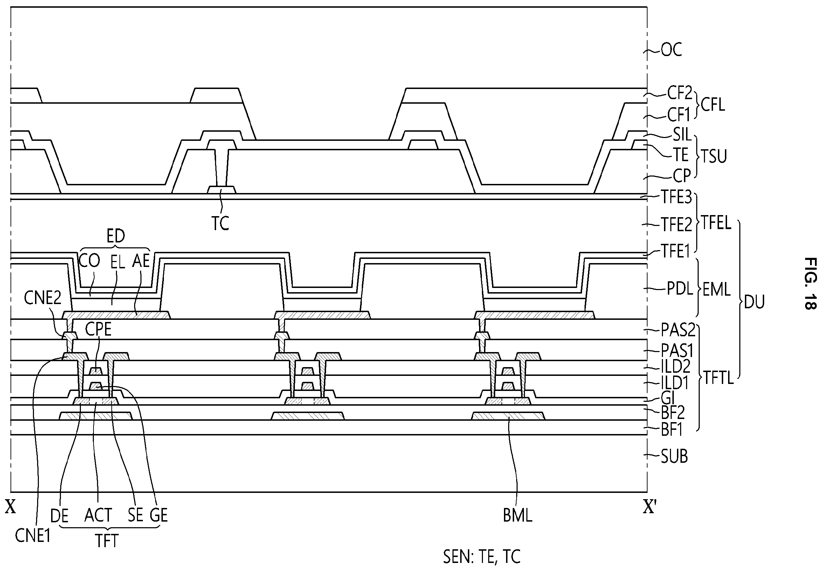

Next, referring to FIG. 18, the overcoat layer OC is formed on the second color filter CF2. The overcoat layer OC may be formed by applying a polymer resin and performing a photolithography process using a mask. The overcoat layer OC may be formed across the emission areas EA1, EA2, and EA3 and the non-emission area NEA while covering the first color filter CF1, the second color filter CF2, and the color pattern CP.

In the manufacturing process of the display device 10 described above, a total of three masks may be used to manufacture the overcoat layer OC and the color filter layer CFL formed on the touch sensing layer TSU. In general, four masks have been used to form a red color filter, a green color filter, a blue color filter, and a black matrix of the color filter layer CFL. In the present disclosure, there is an advantage in that a total of two masks may be reduced by omitting a green color filter and a black matrix.

Hereinafter, a display device according to another embodiment will be described with reference to other drawings.

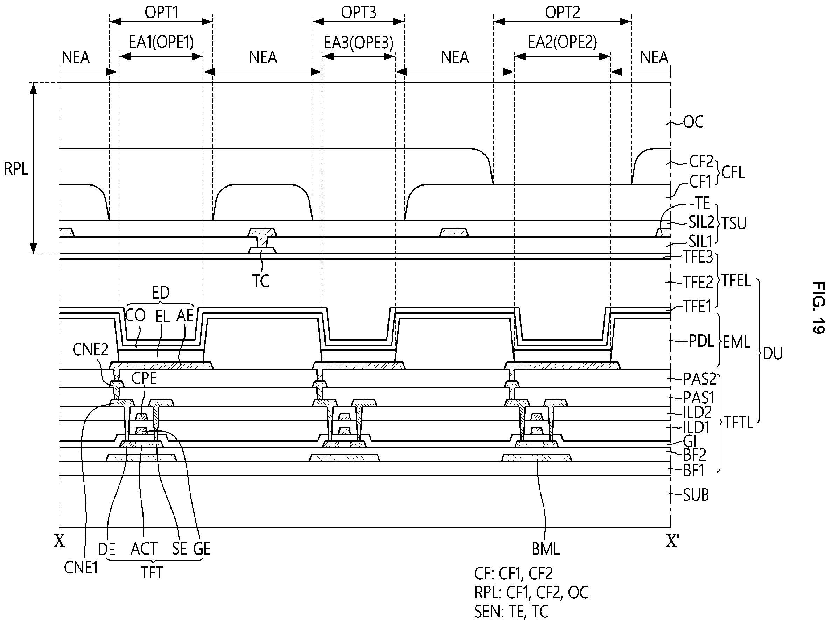

FIG. 19 is a cross-sectional view schematically illustrating a display device according to another embodiment.

Referring to FIG. 19, this embodiment is different from FIG. 10 described above in that the color pattern CP is omitted and the first color filter CF1, which is a blue color filter, and the second color filter CF2, which is a yellow color filter, are formed in the color filter layer CFL. In the following description, redundant description of the above-described embodiments will be omitted while focusing on differences.

The touch sensing layer TSU may be disposed on the encapsulation layer TFEL. The touch sensing layer TSU may include the touch connection electrode TC, a first passivation layer SIL1, the driving electrode TE, and a second passivation layer SIL2.

The touch connection electrode TC may be disposed on the encapsulation layer TFEL. The touch connection electrode TC may serve to connect the driving electrode TE. The touch connection electrode TC may be disposed to overlap the non-emission area NEA.

The first passivation layer SIL1 may have insulating and optical functions. The first passivation layer SIL1 may be disposed on the touch connection electrode TC. The first passivation layer SIL1 may include at least one inorganic layer or organic layer. Optionally, the first passivation layer SIL1 may be omitted.

The driving electrode TE may be disposed on the first passivation layer SIL1. The driving electrode TE may be connected to the touch connection electrode TC. The driving electrode TE may be disposed to overlap the non-emission area NEA.

The second passivation layer SIL2 may be disposed on the first passivation layer SIL1 and the driving electrode TE. The second passivation layer SIL2 may cover the first passivation layer SIL1 and the driving electrode TE. The second passivation layer SIL2 may have insulating and optical functions. For example, the second passivation layer SIL2 may be an organic layer or an inorganic layer including at least one of a silicon nitride layer, a silicon oxy nitride layer, a silicon oxide layer, a titanium oxide layer, or an aluminum oxide layer.

The color filter layer CFL may be disposed on the touch sensing layer TSU. The color filter layer CFL may include the first color filter CF1 and the second color filter CF2.

The first color filter CF1 may be disposed on the second passivation layer SIL2. The first color filter CF1 may be disposed to overlap the second emission area EA2, the second opening OPE2, and the non-emission area NEA. The second color filter CF2 may be disposed so as not to overlap the first emission area EA1 and the third emission area EA3.

The first color filter CF1 may selectively transmit light of a specific wavelength and may block or absorb light of a different wavelength. The first color filter CF1 may be a blue color filter that transmits only the second light of the blue color, and may absorb the first light of the red color and the third light of the green color.

The second color filter CF2 may be disposed on the second passivation layer SIL2 and the first color filter CF1. The second color filter CF2 may be disposed to overlap the first emission area EA1, the first opening OPE1, the third emission area EA3, the third opening OPE3, and the non-emission area NEA. The second color filter CF2 may be disposed so as not to overlap the second emission area EA2.

The second color filter CF2 may selectively transmit light of a specific wavelength and may block or absorb light of a different wavelength. The second color filter CF2 may be a yellow color filter that transmits only fourth light of the yellow color. For example, the second color filter CF2 may transmit the first light of the red color and the third light of the green color and absorb the second light of the blue color.

In one embodiment, the second color filter CF2 may be disposed to overlap the first color filter CF1 in an area other than the second emission area EA2. For example, the second color filter CF2 may be disposed to overlap the first color filter CF1 in the non-emission area NEA. In the remaining area excluding the emission areas EA1, EA2, and EA3, the first color filter CF1 and the second color filter CF2 may overlap each other to act as a black matrix. As a result, it is possible to prevent visible light infiltration and color mixture between the first to third emission areas EA1, EA2, and EA3, which leads to the improvement of color reproducibility of the display device 10. In addition, since the black matrix may be omitted, the structure may be simplified.

Further, the second color filter CF2 is disposed to overlap the first emission area EA1 and the third emission area EA3, so that the first light of the red color, which is emitted from the first emission area EA1, and the third light of the green color, which is emitted from the third emission area EA3, may not be prevented from being transmitted and emitted.

Furthermore, since the first color filter CF1, the second color filter CF2, or the first color filter CF1 and the second color filter CF2 entirely cover the emission areas EA1, EA2, and EA3 and the non-emission area NEA, most of the external light incident from the outside may be absorbed, thereby reducing the reflectance of the external light.

The overcoat layer OC may be disposed on the color filter layer CFL. The overcoat layer OC may cover the color filter layer CFL to flatten the lower step. The overcoat layer OC may include an organic material, and may include, for example, polyimide (PI). Further, as described above, the overcoat layer OC may further include a dye that may selectively absorb light in a specific wavelength band. The overcoat layer OC may reduce the reflectance of external light by absorbing light in a partial wavelength band of light incident from the outside.

According to this embodiment, the color filter layer CFL and the overcoat layer OC may be included as the reflection reduction layer RPL. The reflection reduction layer RPL may reduce the reflection of light incident from the outside. When external light is incident, light in a partial wavelength band is absorbed in the overcoat layer OC, and light in a partial wavelength band is absorbed in the color filter layer CFL. Accordingly, most of the external light incident on the display device 10 is absorbed by the reflection reduction layer RPL, so that the amount of light reflected back to the outside may be significantly reduced.

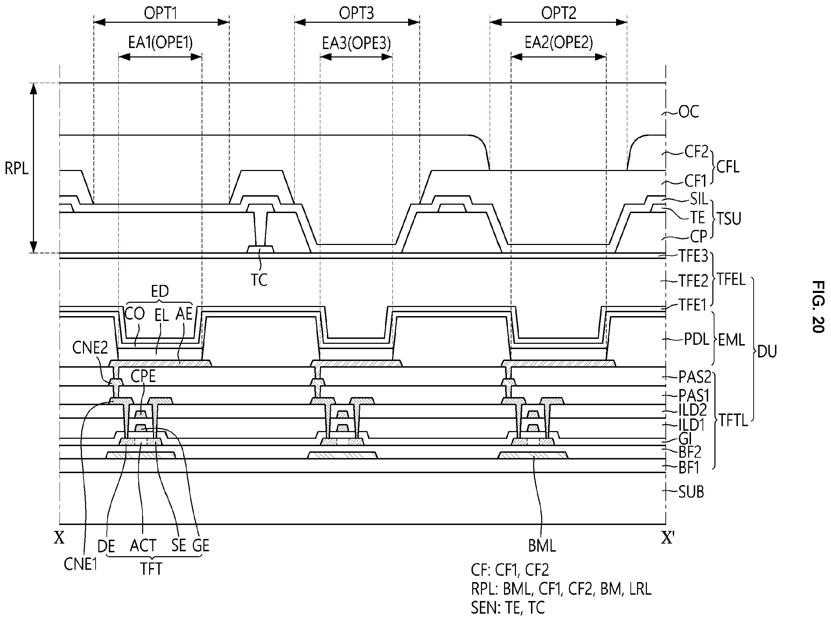

FIG. 20 is a cross-sectional view schematically illustrating a display device according to still another embodiment.

Referring to FIG. 20, this embodiment is different from the embodiment of FIG. 19 in that the touch sensing layer TSU further includes the color pattern CP containing a colorant that absorbs the first light of the red color. In the following description, redundant description of the above-described embodiments will be omitted while focusing on differences.

The touch sensing layer TSU may be disposed on the encapsulation layer TFEL. The touch sensing layer TSU may include the color pattern CP, the touch connection electrode TC, the driving electrode TE, and the passivation layer SIL.

The color pattern CP may be disposed on the encapsulation layer TFEL. The color pattern CP may be disposed to overlap the first emission area EA1, the first opening OPE1, and the non-emission area NEA. The color pattern CP may be disposed so as not to overlap the second emission area EA2 and the third emission area EA3.

The color pattern CP may selectively transmit light of a specific wavelength and may block or absorb light of a different wavelength. The color pattern CP may include a colorant dispersed in a polymer resin. The polymer resin may be a material that is transparent and has a low refractive index. The polymer resin may have a refractive index of 1.4 to 1.6. For example, the polymer resin may include one or more selected from acryl, epoxy, phenol, polyimide, and polyamide resin. The color pattern CP may include a colorant such as a dye or a pigment that absorbs light of a wavelength band other than a specific wavelength band. The color pattern CP may be a red color filter that transmits only the first light of the red color, and may absorb the second light of the blue color and the third light of the green color. The color pattern CP may be formed by coating a solution in which a polymer resin and a colorant are mixed and curing it.

In another embodiment, the color pattern CP may further include a hollow particle. The hollow particle may serve to lower the refractive index of the color pattern CP. For example, the hollow particle may include one or more selected from the group consisting of silica (SiO₂), magnesium fluoride (MgF₂), and iron oxide (Fe₃O₄). The hollow particle included in the color pattern CP may be included in a weight ratio of 1% to 50% relative to a polymer resin, thereby lowering the refractive index of the color pattern CP.

The side surface of the color pattern CP, which is adjacent to each of the emission areas EA1, EA2, EA3, and EA4, may be an inclined surface. An inclination angle θ1 of the inclined surface may be about 60 to 85 degrees, and preferably 70 to 75 degrees. A portion of light emitted from the light emitting elements ED of each emission area EA1, EA2, EA3 may be emitted directly toward the upper portion where the overcoat layer OC is disposed, while another portion of the light may proceed toward the inclined surface of the color pattern CP. In this case, the inclined surface of the color pattern CP acts as a total reflection surface, so that the light incident on the inclined surface of the color pattern CP may be totally reflected to be emitted upward.

The color pattern CP may have a smaller refractive index than the first color filter CF1 and the second color filter CF2. The refractive index of the color pattern CP may be 0.05 or more smaller than the refractive index of the first color filter CF1 and the refractive index of the second color filter CF2. A portion of light refracted at the inclined surface of the color pattern CP may be refracted upward at the boundary of the first color filter CF1 or the second color filter CF2 having a relatively high refractive index, thereby improving the light emission efficiency.

In the touch electrode SEN, the touch connection electrode TC may be disposed under the color pattern CP, and the driving electrode TE may be disposed on the color pattern CP. The touch electrode SEN may overlap the first to third emission areas EA1, EA2, and EA3. The color pattern CP may function as an insulating layer that insulates the touch electrodes SEN.

The passivation layer SIL may insulate the driving electrode TE of the touch electrode SEN, and may serve to protect the lower color pattern CP from subsequent processes.

The color filter layer CFL may be disposed on the touch sensing layer TSU. The color filter layer CFL may include the first color filter CF1 and the second color filter CF2.

The first color filter CF1 may be disposed on the passivation layer SIL. The first color filter CF1 may be disposed to overlap the second emission area EA2, the second opening OPE2, and the non-emission area NEA. The first color filter CF1 may be disposed so as not to overlap the first emission area EA1 and the third emission area EA3. In addition, the first color filter CF1 may be disposed to overlap the color pattern CP in an area other than the second emission area EA2. For example, the first color filter CF1 may be disposed to overlap the color pattern CP in the non-emission area NEA.

The first color filter CF1 may selectively transmit light of a specific wavelength and may block or absorb light of a different wavelength. The first color filter CF1 may be a blue color filter that transmits only the second light of the blue color, and may absorb the first light of the red color and the third light of the green color.

The second color filter CF2 may be disposed on the passivation layer SIL and the first color filter CF1. The second color filter CF2 may be disposed to overlap the first emission area EA1, the first opening OPE1, the third emission area EA3, the third opening OPE3, and the non-emission area NEA. The second color filter CF2 may be disposed so as not to overlap the second emission area EA2.

The second color filter CF2 may selectively transmit light of a specific wavelength and may block or absorb light of a different wavelength. The second color filter CF2 may be a yellow color filter that transmits only fourth light of the yellow color. For example, the second color filter CF2 may transmit the first light of the red color and the third light of the green color and absorb the second light of the blue color.

In one embodiment, the second color filter CF2 may be disposed to overlap the color pattern CP and the first color filter CF1 in an area other than the second emission area EA2. For example, the second color filter CF2 may be disposed to overlap the color pattern CP and the first color filter CF1 in the non-emission area NEA. In the remaining area excluding the emission areas EA1, EA2, and EA3, the color pattern CP, the first color filter CF1, and the second color filter CF2 may overlap each other to act as a black matrix. As a result, it is possible to prevent visible light interference among the emission areas EA1, EA2, EA3, and EA4, which causes color mixture, thereby improving color reproducibility of the display device 10. In addition, since the black matrix may be omitted, the structure may be simplified.

Further, the second color filter CF2 is disposed to overlap the first emission area EA1 and the third emission area EA3, so that the first light of the red color, which is emitted from the first emission area EA1, and the third light of the green color, which is emitted from the third emission area EA3, may not be prevented from being transmitted and emitted.

Furthermore, since the color pattern CP, the first color filter CF1, and the second color filter CF2 entirely cover the emission areas EA1, EA2, and EA3 and the non-emission area NEA, most of the external light incident from the outside may be absorbed, thereby reducing the reflectance of the external light.

The overcoat layer OC may be disposed on the color filter layer CFL. The overcoat layer OC may cover the color filter layer CFL to flatten the lower step. The overcoat layer OC may include an organic material, and may include, for example, polyimide (PI). Further, as described above, the overcoat layer OC may further include a dye that may selectively absorb light in a specific wavelength band. The overcoat layer OC may reduce the reflectance of external light by absorbing light in a partial wavelength band of light incident from the outside.

According to this embodiment, the color pattern CP of the touch sensing layer TSU, the color filter layer CFL, and the overcoat layer OC may be included as the reflection reduction layer RPL. The reflection reduction layer RPL may reduce the reflection of light incident from the outside. When external light is incident, light in a partial wavelength band is absorbed in the overcoat layer OC, light in a partial wavelength band is absorbed in the color filter layer CFL, and light in a partial wavelength band is absorbed in the color pattern CP. Accordingly, most of the external light incident on the display device 10 is absorbed by the reflection reduction layer RPL, so that the amount of light reflected back to the outside may be significantly reduced.

In addition, since the color pattern CP is formed to have a low refractive characteristic with a total reflection surface, light emitted from each of the emission areas EA1, EA2, and EA3 is reflected upward, thereby improving the light emission efficiency.

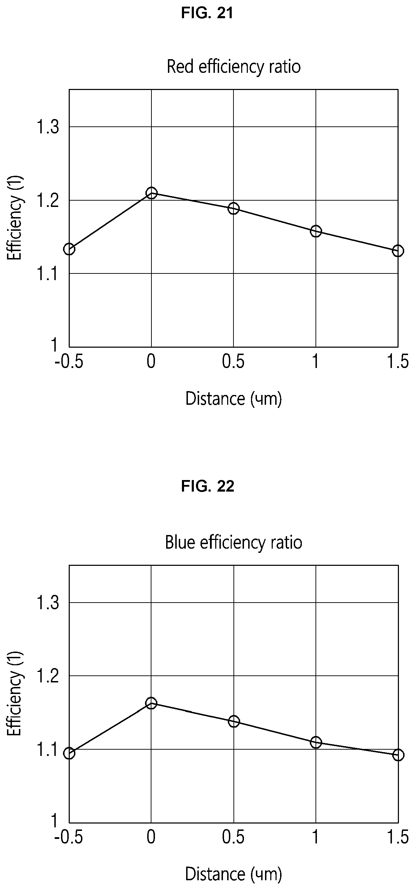

FIG. 21 is a graph obtained by simulating a red light efficiency ratio according to a distance between lateral sides of a pixel defining layer and a color pattern. FIG. 22 is a graph obtained by simulating a blue light efficiency ratio according to a distance between lateral sides of a pixel defining layer and of a color pattern.

Referring to FIG. 21, it can be seen that the red light efficiency ratio was highest to be 1.2 when the distance between the lateral sides of the pixel defining layer and the color pattern was 0, and the red light efficiency ratio was high to be 1.1 or more when the distance was in a range of -0.5 µm to 1.5 µm.

Referring to FIG. 22, it can be seen that the blue light efficiency ratio was highest to be 1.16 when the distance between the lateral sides of the pixel defining layer and the color pattern was 0, and the red light efficiency ratio was high to be 1.1 or more when the distance was in a range of -0.5 µm to 1.5 µm.

These results show that the distance between the lateral sides of the pixel defining layer and the color pattern in the range of -0.5 µm to 1.5 µm is advantageous in terms of light efficiency.

Table 1 below shows results of simulating light efficiency and a reflection characteristic according to a structure of a display device. FIG. 23 is a graph showing a transmittance by a wavelength band of a yellow color filter used in the simulation. FIG. 24 is a graph showing a transmittance by a wavelength band of a dye with a maximum absorption wavelength of 490 nm used in the simulation. FIG. 25 is a graph showing a transmittance by a wavelength band of a dye with a maximum absorption wavelength of 590 nm used in the simulation.

In Table 1 below, Example 1 is according to the structure shown in FIG. 10 and was configured with the color pattern CP transmitting green light, the first color filter CF1 transmitting red light, the second color filter CF2 transmitting blue light, and the overcoat layer OC containing a dye with a maximum absorption wavelength of 590 nm. Example 2 is according to the structure shown in FIG. 19 and was configured with the first color filter CF1 transmitting blue light, the second color filter CF2 transmitting yellow light, and the overcoat layer OC containing dyes with maximum absorption wavelengths of 590 nm and 490 nm. Example 3 is according to the structure shown in FIG. 20 and was configured with the color pattern CP transmitting red light, the first color filter CF1 transmitting blue light, the second color filter CF2 transmitting yellow light, and the overcoat layer OC containing dyes with maximum absorption wavelengths of 590 nm and 490 nm. Further, as a Comparative Example, a display device was configured with a color filter layer including a red color filter, a green color filter, a blue color filter, and a black matrix and an overcoat layer containing a transparent material, without a color pattern.

Furthermore, in Table 1 below, efficiency refers to the light efficiency of each of the white (W) color, red (R) color, green (G) color, and blue (B) color, and reflection characteristic refers to the external light reflectance of a display device. The unit of each value is %.

**[Table 1]**

| | | Comparative Example | Example 1 | Example 2 | Example 3 |
|---|---|---|---|---|---|
| Efficiency | W | 158.7 | 175.0 | 175.5 | 175.6 |
| | R | 164.5 | 180.6 | 150.7 | 144.0 |
| | G | 117.4 | 134.7 | 152.1 | 158.1 |
| | B | 161.5 | 170.4 | 170.4 | 170.4 |
| Reflectance | SCI | 5.58 | 5.39 | 6.31 | 5.82 |
| | CIE x | 0.292 | 0.291 | 0.316 | 0.318 |
| | CIE y | 0.310 | 0.314 | 0.338 | 0.324 |

Referring to Table 1, compared to the Comparative Example, the efficiency of white light, green light, and blue light was increased in each of Examples 1 to 3. In addition, compared to the Comparative Example, Example 1 had a reduced external light reflectance. Through these results, it was confirmed that the display devices according to the embodiments are capable of increasing the light efficiency and reducing the reflectance of external light in some structures.

In concluding the detailed description, those skilled in the art will appreciate that many variations and modifications may be made to the embodiments without substantially departing from the principles of the disclosure. Therefore, the disclosed embodiments are used in a generic and descriptive sense only and not for purposes of limitation.

## Claims

1. A display device comprising:
a substrate;
a light emitting element layer disposed on the substrate, and comprising a pixel defining layer defining a plurality of emission areas and a non-emission area;
an encapsulation layer disposed on the light emitting element layer;
a touch sensing layer disposed on the encapsulation layer, and comprising a touch connection electrode, a driving electrode, and a color pattern disposed between the touch connection electrode and the driving electrode;
a color filter layer disposed on the touch sensing layer, and comprising a plurality of color filters; and
an overcoat layer disposed on the color filter layer,
wherein the color pattern overlaps one of the plurality of emission areas and the non-emission area, and
the plurality of color filters do not overlap the emission area which overlaps the color pattern.

2. The display device of claim 1, wherein the plurality of emission areas comprise a first emission area which emits first light, a second emission area which emits second light, and a third emission area which emits third light, and
the color pattern overlaps any one emission area selected from the first emission area, the second emission area, and the third emission area.

3. The display device of claim 2, wherein the plurality of color filters are disposed to overlap different emission areas, respectively, among the remaining emission areas excluding the emission area overlapping the color pattern.

4. The display device of claim 3, wherein the first light is red light, the second light is blue light, and the third light is green light.

5. The display device of claim 4, wherein the color pattern overlaps the third emission area and does not overlap the first emission area and the second emission area.

6. The display device of claim 5, wherein the color pattern contains a colorant which transmits the third light and absorbs the first light and the second light.

7. The display device of claim 4, wherein the plurality of color filters comprise a first color filter which transmits the first light and a second color filter which transmits the second light, the first color filter overlaps the first emission area, and the second color filter overlaps the second emission area.

8. The display device of claim 1, wherein the color pattern and the plurality of color filters overlap each other in the non-emission area.

9. The display device of claim 1, wherein the color pattern has a refractive index smaller than that of the plurality of color filters.

10. The display device of claim 9, wherein the color pattern has a refractive index which is 0.05 or more smaller than the refractive index of the plurality of color filters.

11. The display device of claim 1, wherein the overcoat layer contains at least one of a dye with a maximum absorption wavelength of 490 nm or a dye with a maximum absorption wavelength of 590 nm.

12. The display device of claim 11, wherein the dye absorbs light in a wavelength band of 480 nm to 500 nm or 580 nm to 600 nm.

13. The display device of claim 1, wherein a lateral side of the color pattern is disposed at a distance of 2 µm or less outward from a lateral side of the pixel defining layer and at a distance of 1 µm or less inward from the lateral side of the pixel defining layer.

14. A display device comprising:
a substrate;
a light emitting element layer disposed on the substrate, and comprising a pixel defining layer defining a plurality of emission areas and a non-emission area;
an encapsulation layer disposed on the light emitting element layer;
a touch sensing layer disposed on the encapsulation layer, and comprising a touch connection electrode, a driving electrode, and a color pattern disposed between the touch connection electrode and the driving electrode;
a color filter layer disposed on the touch sensing layer, and comprising a first color filter and a second color filter; and
an overcoat layer disposed on the color filter layer,
wherein the color pattern overlaps one of the plurality of emission areas and the non-emission area, and
the first color filter does not overlap the emission area which overlaps the color pattern, and the second color filter overlaps the emission area which overlaps the color pattern.

15. The display device of claim 14, wherein the plurality of emission areas comprise a first emission area which emits first light of a red color, a second emission area which emits second light of a blue color, and a third emission area which emits third light of a green color, and
the color pattern overlaps the first emission area, the first color filter overlaps the second emission area, and the second color filter overlaps the first emission area and the third emission area.

16. The display device of claim 15, wherein the color pattern is a red color filter which transmits the first light, the first color filter is a blue color filter which transmits the second light, and the second color filter is a yellow color filter which transmits the first light and the third light.

17. The display device of claim 16, wherein the color pattern, the first color filter, and the second color filter overlap each other in the non-emission area.

18. The display device of claim 16, wherein the color pattern does not overlap the second emission area and the third emission area, the first color filter does not overlap the first emission area and the third emission area, and the second color filter does not overlap the second emission area.

19. A display device comprising:
a substrate;
a light emitting element layer disposed on the substrate, and comprising a pixel defining layer defining a plurality of emission areas and a non-emission area;
an encapsulation layer disposed on the light emitting element layer;
a touch sensing layer disposed on the encapsulation layer, and comprising a plurality of touch electrodes;
a color filter layer disposed on the touch sensing layer, and comprising a plurality of color filters; and
an overcoat layer disposed on the color filter layer,
wherein the plurality of color filters comprise a first color filter and a second color filter,
the first color filter overlaps one of the plurality of emission areas, and
the second color filter is disposed to overlap the remaining two or more emission areas among the plurality of emission areas.

20. The display device of claim 19, wherein the plurality of emission areas comprise a first emission area which emits first light of a red color, a second emission area which emits second light of a blue color, and a third emission area which emits third light of a green color, and
the first color filter is a blue color filter which transmits the second light of the blue color, and the second color filter is a yellow color filter which transmits the first light of the red color and the third light of the green color.

21. The display device of claim 20, wherein the first color filter overlaps the second emission area and the non-emission area, and the second color filter overlaps the first emission area, the third emission area, and the non-emission area.
